# EUROPEAN PATENT SPECIFICATION

(11) **EP 4 523 045 B1**
(45) Date of publication and mention of the grant of the patent: **04.11.2026**
(21) Application number: 23722572.7
(22) Date of filing: 28.04.2023
(51) Int. Cl.: G03F 7/20

(54) **A MOVABLE STAGE FOR A LITHOGRAPHIC APPARATUS**
BEWEGLICHE TRÄGERPLATTE FÜR EINEN LITHOGRAPHISCHEN APPARAT
PLATINE MOBILE POUR APPAREIL LITHOGRAPHIQUE

(30) Priority: 12.05.2022 US 202263341304 P; 08.03.2023 US 202363450877 P
(43) Date of publication of application: 19.03.2025
(73) Proprietor: ASML Netherlands B.V., 5500 AH Veldhoven (NL)
(72) Inventor: DEL PUERTO, Santiago E., Wilton, Connecticut 06897 (US); ROUX, Stephen, Wilton, Connecticut 06897 (US)
(74) Representative: ASML Netherlands B.V.
(86) International application number: PCT/EP2023/061250
(87) International publication number: WO 2023/217553

(56) References cited:
- EP-B1- 1 983 371
- US-A1- 2005 185 167
- US-A1- 2005 200 827
- US-A1- 2011 149 263
- "A MOVABLE STAGE FOR A LITHOGRAPHIC APPARATUS", vol. 699, no. 10, 26 May 2022 (2022-05-26), XP007150356, ISSN: 0374-4353, Retrieved from the Internet <URL:ftp://ftppddoc/RDData699_EPO.zip Pdf/699010.pdf> [retrieved on 20220526]

## Description

### CROSS-REFERENCE TO RELATED APPLICATIONS

This application claims priority of US application 63/341,304 which was filed on May 12, 2022 and US application 63/450,877 which was filed on March 8, 2023.

### FIELD

The present disclosure relates to actuated stages, for example, a stage for supporting a reticle used in lithographic apparatuses and systems.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, can be used to generate a circuit pattern to be formed on an individual layer of the IC. This pattern can be transferred onto a target portion (e.g., comprising part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the target portions parallel or anti-parallel to this scanning direction. It is also possible to transfer the pattern from the patterning device to the substrate by imprinting the pattern onto the substrate.

During lithographic operation, different processing steps can require different layers to be sequentially formed on the substrate. Accordingly, it can be necessary to position the substrate relative to prior patterns formed thereon with a high degree of accuracy. Generally, alignment marks are placed on the substrate to be aligned and are located with reference to a second object. A lithographic apparatus can use an alignment apparatus for detecting positions of the alignment marks and for aligning the substrate using the alignment marks to ensure accurate exposure from a mask. Misalignment between the alignment marks at two different layers is measured as overlay error.

In order to monitor the lithographic process, parameters of the patterned substrate are measured. Parameters can include, for example, the overlay error between successive layers formed in or on the patterned substrate and critical linewidth of developed photosensitive resist. This measurement can be performed on a product substrate and/or on a dedicated metrology target. There are various techniques for making measurements of the microscopic structures formed in lithographic processes, including the use of scanning electron microscopes and various specialized tools. A fast and non-invasive form of a specialized inspection tool is a scatterometer in which a beam of radiation is directed onto a target on the surface of the substrate and properties of the scattered or reflected beam are measured. By comparing the properties of the beam before and after it has been reflected or scattered by the substrate, the properties of the substrate can be determined. This can be done, for example, by comparing the reflected beam with data stored in a library of known measurements associated with known substrate properties. Spectroscopic scatterometers direct a broadband radiation beam onto the substrate and measure the spectrum (intensity as a function of wavelength) of the radiation scattered into a particular narrow angular range. By contrast, angularly resolved scatterometers use a monochromatic radiation beam and measure the intensity of the scattered radiation as a function of angle.

Such optical scatterometers can be used to measure parameters, such as critical dimensions of developed photosensitive resist or overlay error (OV) between two layers formed in or on the patterned substrate. Properties of the substrate can be determined by comparing the properties of an illumination beam before and after the beam has been reflected or scattered by the substrate.

A lithographic system can output only a finite number of fabricated devices in a given timeframe. Fast scanning of wafer stages and reticle stages can improve the speed of fabrication. However, high accelerations can cause the stages to distort under mechanical stresses

US 2005/185167 A1 is directed to a positioning system comprising a reticle plate with magnetic material plates and electromagnets disposed at left- and right-hand side positions and on the opposite side surfaces of the reticle top plate.

### SUMMARY

The invention is set out in the appended set of claims. The first aspect of the invention is a lithographic apparatus according to claim 1 and the second aspect of the invention is a stage according to claim 8.

Accordingly, it is desirable to improve fabrication speed and throughput. Wafer and reticle stages can be made to withstand high accelerations according to aspects described herein.

In some aspects, a lithographic apparatus comprises an illumination system, a projection system, and a stage. The illumination system is configured to illuminate a pattern of a patterning device. The projection system is configured to project an image of the pattern onto a substrate. The stage is configured to move the patterning device or the substrate. The stage comprises first and second support structures, an actuator device, an actuator target, and a shaft. The first support structure is configured to support the patterning device or the substrate. The second support structure is configured to support the first support structure. The actuator device is disposed on the second support structure and is configured to move the first support structure along a direction. The actuator target is configured to interact with the actuator device. The shaft affixed to the actuator target and a location at the first support structure. The shaft is configured to transmit a mechanical load from the actuator target to the location.

In some aspects, a movable stage comprises first and second support structures, an actuator device, an actuator target, and a shaft. The first support structure is configured to support an object. The second support structure is configured to support the first support structure. The actuator device is disposed on the second support structure and is configured to move the first support structure along a direction. The actuator target is configured to interact with the actuator device. The shaft affixed to the actuator target and a location at the first support structure. The shaft is configured to transmit a mechanical load from the actuator target to the location.

In some aspects, a lithographic apparatus comprises an illumination system, a projection system, and a stage. The illumination system is configured to illuminate a pattern of a patterning device. The projection system is configured to project an image of the pattern onto a substrate. The stage is configured to move the patterning device or the substrate. The stage comprises a support structure, an actuator device, a tensional member, and first, second, and third actuator targets. The support structure is configured to support the patterning device or the substrate. The first actuator target is disposed at a first side of the support structure. The second actuator target is disposed at a second side of the support structure opposite the first side. The third actuator target is attached to the first side of the support structure. The actuator device is disposed proximal to the first and third targets. The actuator device is configured to magnetically interact with the first and third targets to move the support structure along a direction. The first and second actuator targets are attached at opposite ends of the tensional member. The tensional member is configured to transmit a mechanical load to the second side of the support structure via the second actuator target based on a magnetic force exerted on the first actuator target.

In some aspects, a stage comprises a support structure, an actuator device, a tensional member, and first, second, and third actuator targets. The support structure is configured to support an object. The first actuator target is disposed at a first side of the support structure. The second actuator target is disposed at a second side of the support structure opposite the first side. The third actuator target is attached to the first side of the support structure. The actuator device is disposed proximal to the first and third targets. The actuator device is configured to magnetically interact with the first and third targets to move the support structure along a direction. The first and second actuator targets are attached at opposite ends of the tensional member. The tensional member is configured to transmit a mechanical load to the second side of the support structure via the second actuator target based on a magnetic force exerted on the first actuator target.

Further features of the present disclosure, as well as the structure and operation of various aspects, are described in detail below with reference to the accompanying drawings. It is noted that the present disclosure is not limited to the specific aspects described herein. Such aspects are presented herein for illustrative purposes only. Additional aspects will be apparent to persons skilled in the relevant art(s) based on the teachings contained herein.

### BRIEF DESCRIPTION OF THE DRAWINGS/FIGURES

The accompanying drawings, which are incorporated herein and form part of the specification, illustrate the present disclosure and, together with the description, further serve to explain the principles of the present disclosure and to enable a person skilled in the relevant art(s) to make and use aspects described herein.
FIG. 1A shows a schematic of a reflective lithographic apparatus, according to some aspects.
FIG. 1B shows a schematic of a transmissive lithographic apparatus, according to some aspects.
FIG. 2 shows a more detailed schematic of the reflective lithographic apparatus, according to some aspects.
FIG. 3 shows a schematic of a lithographic cell, according to some aspects.
FIGS. 4A and 4B show schematics of inspection apparatuses, according to some aspects.
FIGS. 5-6, 7A and 7B show actuated stages, according to some aspects.
FIG. 8 shows a section of a support structure of a stage, according to some aspects.
FIGS. 9 and 10 show actuated stages, according to some aspects.

The features of the present disclosure will become more apparent from the detailed description set forth below when taken in conjunction with the drawings, in which like reference characters identify corresponding elements throughout. In the drawings, like reference numbers generally indicate identical, functionally similar, and/or structurally similar elements. Additionally, generally, the leftmost digit(s) of a reference number identifies the drawing in which the reference number first appears. Unless otherwise indicated, the drawings provided throughout the disclosure should not be interpreted as to-scale drawings.

### DETAILED DESCRIPTION

This specification discloses one or more aspects that incorporate the features of the present disclosure. The disclosed aspect(s) are provided as examples. The scope of the present disclosure is not limited to the disclosed aspect(s). Claimed features are defined by the claims appended hereto.

The aspect(s) described, and references in the specification to "one aspect," "an aspect," "an example aspect," etc., indicate that the aspect(s) described can include a particular feature, structure, or characteristic, but every aspect may not necessarily include the particular feature, structure, or characteristic. Moreover, such phrases are not necessarily referring to the same aspect. Further, when a particular feature, structure, or characteristic is described in connection with an aspect, it is understood that it is within the knowledge of one skilled in the art to effect such feature, structure, or characteristic in connection with other aspects whether or not explicitly described.

Spatially relative terms, such as "beneath," "below," "lower," "above," "on," "upper" and the like, can be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus can be otherwise oriented (rotated 90 degrees or at other orientations) and the spatially relative descriptors used herein can likewise be interpreted accordingly.

The term "about" as used herein indicates the value of a given quantity that can vary based on a particular technology. Based on the particular technology, the term "about" can indicate a value of a given quantity that varies within, for example, 10-30% of the value (e.g., ±10%, ±20%, or ±30% of the value).

Aspects of the disclosure can be implemented in hardware, firmware, software, or any combination thereof. Aspects of the disclosure can also be implemented as instructions stored on a machine-readable medium, which can be read and executed by one or more processors. A machine-readable medium can include any mechanism for storing or transmitting information in a form readable by a machine (e.g., a computing device). For example, a machine-readable medium can include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others. Further, firmware, software, routines, and/or instructions can be described herein as performing certain actions. However, it should be appreciated that such descriptions are merely for convenience and that such actions in fact result from computing devices, processors, controllers, or other devices executing the firmware, software, routines, instructions, etc.

Before describing such aspects in more detail, however, it is instructive to present an example environment in which aspects of the present disclosure can be implemented.

### Example Lithographic Systems

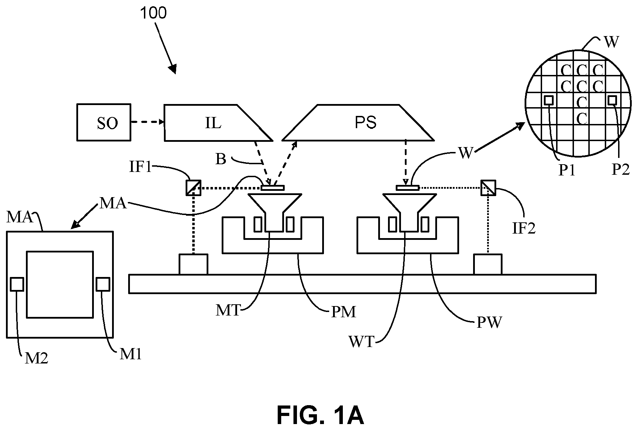

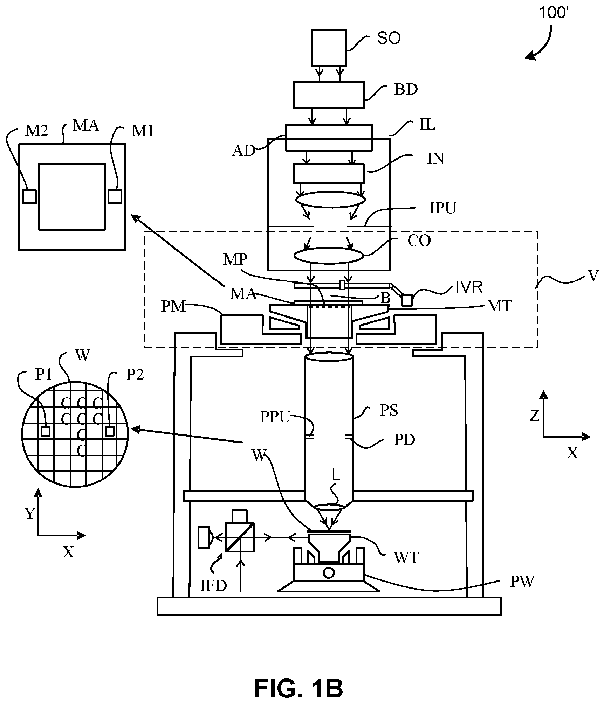

FIGS. 1A and 1B show schematic illustrations of a lithographic apparatus 100 and lithographic apparatus 100', respectively, in which aspects of the present disclosure can be implemented. Lithographic apparatus 100 and lithographic apparatus 100' each include the following: an illumination system (illuminator) IL configured to condition a radiation beam B (for example, deep ultra violet or extreme ultra violet radiation); a support structure (for example, a mask table) MT configured to support a patterning device (for example, a mask, a reticle, or a dynamic patterning device) MA and connected to a first positioner PM configured to accurately position the patterning device MA; and, a substrate table (for example, a wafer table) WT configured to hold a substrate (for example, a resist coated wafer) W and connected to a second positioner PW configured to accurately position the substrate W. Lithographic apparatus 100 and 100' also have a projection system PS configured to project a pattern imparted to the radiation beam B by patterning device MA onto a target portion (for example, comprising one or more dies) C of the substrate W. In lithographic apparatus 100, the patterning device MA and the projection system PS are reflective. In lithographic apparatus 100', the patterning device MA and the projection system PS are transmissive.

The illumination system IL can include various types of optical components, such as refractive, reflective, catadioptric, magnetic, electromagnetic, electrostatic, or other types of optical components, or any combination thereof, for directing, shaping, or controlling the radiation beam B.

The support structure MT holds the patterning device MA in a manner that depends on the orientation of the patterning device MA with respect to a reference frame, the design of at least one of the lithographic apparatus 100 and 100', and other conditions, such as whether or not the patterning device MA is held in a vacuum environment. The support structure MT can use mechanical, vacuum, electrostatic, or other clamping techniques to hold the patterning device MA. The support structure MT can be a frame or a table, for example, which can be fixed or movable, as required. By using sensors, the support structure MT can ensure that the patterning device MA is at a desired position, for example, with respect to the projection system PS.

The term "patterning device" MA should be broadly interpreted as referring to any device that can be used to impart a radiation beam B with a pattern in its cross-section, such as to create a pattern in the target portion C of the substrate W. The pattern imparted to the radiation beam B can correspond to a particular functional layer in a device being created in the target portion C to form an integrated circuit.

The terms "inspection apparatus," "metrology system," or the like can be used herein to refer to, e.g., a device or system used for measuring a property of a structure (e.g., overlay error, critical dimension parameters) or used in a lithographic apparatus to inspect an alignment of a wafer (e.g., alignment apparatus).

The patterning device MA can be transmissive (as in lithographic apparatus 100' of FIG. 1B) or reflective (as in lithographic apparatus 100 of FIG. 1A). Examples of patterning devices MA include reticles, masks, programmable mirror arrays, or programmable LCD panels. Masks are well known in lithography, and include mask types such as binary, alternating phase shift, or attenuated phase shift, as well as various hybrid mask types. An example of a programmable mirror array employs a matrix arrangement of small mirrors, each of which can be individually tilted so as to reflect an incoming radiation beam in different directions. The tilted mirrors impart a pattern in the radiation beam B, which is reflected by a matrix of small mirrors.

The term "projection system" PS can encompass any type of projection system, including refractive, reflective, catadioptric, magnetic, electromagnetic and electrostatic optical systems, or any combination thereof, as appropriate for the exposure radiation being used, or for other factors, such as the use of an immersion liquid on the substrate W or the use of a vacuum. A vacuum environment can be used for EUV or electron beam radiation since other gases can absorb too much radiation or electrons. A vacuum environment can therefore be provided to the whole beam path with the aid of a vacuum wall and vacuum pumps.

Lithographic apparatus 100 and/or lithographic apparatus 100' can be of a type having two (dual stage) or more substrate tables WT (and/or two or more mask tables). In such "multiple stage" machines, the additional substrate tables WT can be used in parallel, or preparatory steps can be carried out on one or more tables while one or more other substrate tables WT are being used for exposure. In some situations, the additional table may not be a substrate table WT.

The lithographic apparatus can also be of a type wherein at least a portion of the substrate can be covered by a liquid having a relatively high refractive index, e.g., water, so as to fill a space between the projection system and the substrate. An immersion liquid can also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to FIGS. 1A and 1B, the illuminator IL receives a radiation beam from a radiation source SO. The source SO and the lithographic apparatus 100, 100' can be separate physical entities, for example, when the source SO is an excimer laser. In such cases, the source SO is not considered to form part of the lithographic apparatus 100 or 100', and the radiation beam B passes from the source SO to the illuminator IL with the aid of a beam delivery system BD (in FIG. 1B) including, for example, suitable directing mirrors and/or a beam expander. In other cases, the source SO can be an integral part of the lithographic apparatus 100, 100', for example, when the source SO is a mercury lamp. The source SO and the illuminator IL, together with the beam delivery system BD, if required, can be referred to as a radiation system.

The illuminator IL can include an adjuster AD (in FIG. 1B) for adjusting the angular intensity distribution of the radiation beam. Generally, at least the outer and/or inner radial extent (commonly referred to as "σ-outer" and "σ-inner," respectively) of the intensity distribution in a pupil plane of the illuminator can be adjusted. In addition, the illuminator IL can comprise various other components (in FIG. 1B), such as an integrator IN and a condenser CO. The illuminator IL can be used to condition the radiation beam B to have a desired uniformity and intensity distribution in its cross section.

Referring to FIG. 1A, the radiation beam B is incident on the patterning device (for example, mask) MA, which is held on the support structure (for example, mask table) MT, and is patterned by the patterning device MA. In lithographic apparatus 100, the radiation beam B is reflected from the patterning device (for example, mask) MA. After being reflected from the patterning device (for example, mask) MA, the radiation beam B passes through the projection system PS, which focuses the radiation beam B onto a target portion C of the substrate W. With the aid of the second positioner PW and position sensor IF2 (for example, an interferometric device, linear encoder, or capacitive sensor), the substrate table WT can be moved accurately (for example, so as to position different target portions C in the path of the radiation beam B). Similarly, the first positioner PM and another position sensor IF1 can be used to accurately position the patterning device (for example, mask) MA with respect to the path of the radiation beam B. Patterning device (for example, mask) MA and substrate W can be aligned using mask alignment marks M1, M2 and substrate alignment marks P1, P2.

Referring to FIG. 1B, the radiation beam B is incident on the patterning device (for example, mask MA), which is held on the support structure (for example, mask table MT), and is patterned by the patterning device. Having traversed the mask MA, the radiation beam B passes through the projection system PS, which focuses the beam onto a target portion C of the substrate W. The projection system has a pupil conjugate PPU to an illumination system pupil IPU. Portions of radiation emanate from the intensity distribution at the illumination system pupil IPU and traverse a mask pattern without being affected by diffraction at the mask pattern and create an image of the intensity distribution at the illumination system pupil IPU.

The projection system PS projects an image of the mask pattern MP, where the image is formed by diffracted beams produced from the mark pattern MP by radiation from the intensity distribution, onto a photoresist layer coated on the substrate W. For example, the mask pattern MP can include an array of lines and spaces. A diffraction of radiation at the array and different from zeroth order diffraction generates diverted diffracted beams with a change of direction in a direction perpendicular to the lines. Undiffracted beams (i.e., so-called zeroth order diffracted beams) traverse the pattern without any change in propagation direction. The zeroth order diffracted beams traverse an upper lens or upper lens group of the projection system PS, upstream of the pupil conjugate PPU of the projection system PS, to reach the pupil conjugate PPU. The portion of the intensity distribution in the plane of the pupil conjugate PPU and associated with the zeroth order diffracted beams is an image of the intensity distribution in the illumination system pupil IPU of the illumination system IL. The aperture device PD, for example, is disposed at or substantially at a plane that includes the pupil conjugate PPU of the projection system PS.

The projection system PS is arranged to capture, by means of a lens or lens group L, not only the zeroth order diffracted beams, but also first-order or first- and higher-order diffracted beams (not shown). In some aspects, dipole illumination for imaging line patterns extending in a direction perpendicular to a line can be used to utilize the resolution enhancement effect of dipole illumination. For example, first-order diffracted beams interfere with corresponding zeroth-order diffracted beams at the level of the wafer W to create an image of the line pattern MP at highest possible resolution and process window (i.e., usable depth of focus in combination with tolerable exposure dose deviations). In some aspects, astigmatism aberration can be reduced by providing radiation poles (not shown) in opposite quadrants of the illumination system pupil IPU. Further, in some aspects, astigmatism aberration can be reduced by blocking the zeroth order beams in the pupil conjugate PPU of the projection system associated with radiation poles in opposite quadrants. This is described in more detail in US 7,511,799 B2, issued Mar. 31, 2009.

With the aid of the second positioner PW and position sensor IFD (for example, an interferometric device, linear encoder, or capacitive sensor), the substrate table WT can be moved accurately (for example, so as to position different target portions C in the path of the radiation beam B). Similarly, the first positioner PM and another position sensor (not shown in FIG. 1B) can be used to accurately position the mask MA with respect to the path of the radiation beam B (for example, after mechanical retrieval from a mask library or during a scan).

In general, movement of the mask table MT can be realized with the aid of a long-stroke module (coarse positioning) and a short-stroke module (fine positioning), which form part of the first positioner PM. Similarly, movement of the substrate table WT can be realized using a long-stroke module and a short-stroke module, which form part of the second positioner PW. In the case of a stepper (as opposed to a scanner), the mask table MT can be connected to a short-stroke actuator only or can be fixed. Mask MA and substrate W can be aligned using mask alignment marks M1, M2, and substrate alignment marks P1, P2. Although the substrate alignment marks (as illustrated) occupy dedicated target portions, they can be located in spaces between target portions (known as scribe-lane alignment marks). Similarly, in situations in which more than one die is provided on the mask MA, the mask alignment marks can be located between the dies.

Mask table MT and patterning device MA can be in a vacuum chamber V, where an in-vacuum robot IVR can be used to move patterning devices such as a mask in and out of vacuum chamber. Alternatively, when mask table MT and patterning device MA are outside of the vacuum chamber, an out-of-vacuum robot can be used for various transportation operations, similar to the in-vacuum robot IVR. Both the in-vacuum and out-of-vacuum robots need to be calibrated for a smooth transfer of any payload (e.g., mask) to a fixed kinematic mount of a transfer station.

The lithographic apparatus 100 and 100' can be used in at least one of the following modes:
1. In step mode, the support structure (for example, mask table) MT and the substrate table WT are kept essentially stationary, while an entire pattern imparted to the radiation beam B is projected onto a target portion C at one time (i.e., a single static exposure). The substrate table WT is then shifted in the X and/or Y direction so that a different target portion C can be exposed.
2. In scan mode, the support structure (for example, mask table) MT and the substrate table WT are scanned synchronously while a pattern imparted to the radiation beam B is projected onto a target portion C (i.e., a single dynamic exposure). The velocity and direction of the substrate table WT relative to the support structure (for example, mask table) MT can be determined by the (de-)magnification and image reversal characteristics of the projection system PS.
3. In another mode, the support structure (for example, mask table) MT is kept substantially stationary holding a programmable patterning device, and the substrate table WT is moved or scanned while a pattern imparted to the radiation beam B is projected onto a target portion C. A pulsed radiation source SO can be employed and the programmable patterning device is updated as required after each movement of the substrate table WT or in between successive radiation pulses during a scan. This mode of operation can be readily applied to maskless lithography that utilizes a programmable patterning device, such as a programmable mirror array.

Combinations and/or variations on the described modes of use or entirely different modes of use can also be employed.

In a further aspect, lithographic apparatus 100 includes an extreme ultraviolet (EUV) source, which is configured to generate a beam of EUV radiation for EUV lithography. In general, the EUV source is configured in a radiation system, and a corresponding illumination system is configured to condition the EUV radiation beam of the EUV source.

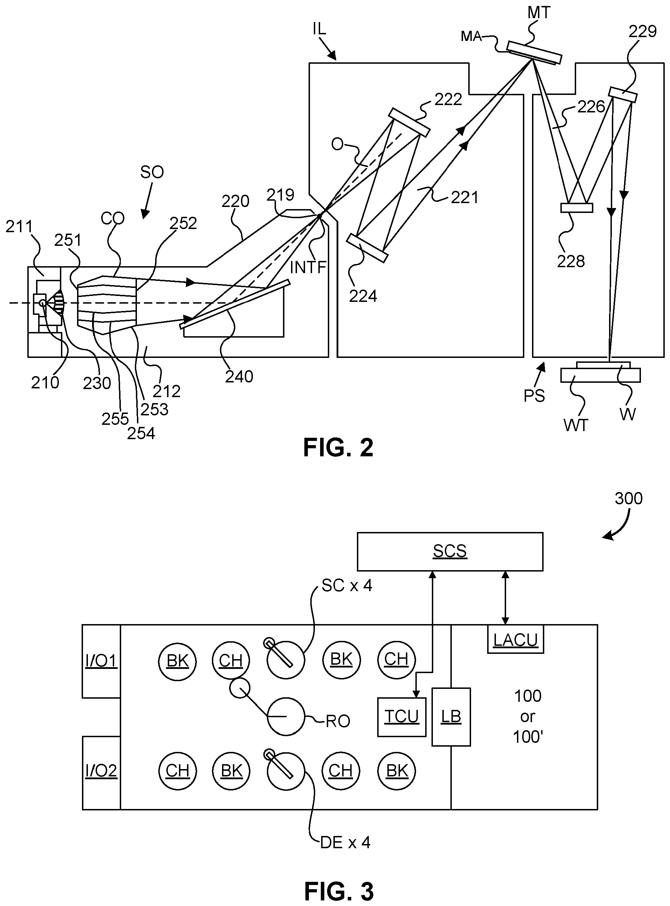

FIG. 2 shows the lithographic apparatus 100 in more detail, including the source collector apparatus SO, the illumination system IL, and the projection system PS. The source collector apparatus SO is constructed and arranged such that a vacuum environment can be maintained in an enclosing structure 220 of the source collector apparatus SO. An EUV radiation emitting plasma 210 can be formed by a discharge produced plasma source. EUV radiation can be produced by a gas or vapor, for example Xe gas, Li vapor, or Sn vapor in which the very hot plasma 210 is created to emit radiation in the EUV range of the electromagnetic spectrum. The very hot plasma 210 is created by, for example, an electrical discharge causing at least a partially ionized plasma. Partial pressures of, for example, 10 Pa of Xe, Li, Sn vapor, or any other suitable gas or vapor can be required for efficient generation of the radiation. In some aspects, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap), which is positioned in or behind an opening in source chamber 211. The contaminant trap 230 can include a channel structure. Contamination trap 230 can also include a gas barrier or a combination of a gas barrier and a channel structure. The contaminant trap or contaminant barrier 230 further indicated herein at least includes a channel structure.

The collector chamber 212 can include a radiation collector CO, which can be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point INTF. The virtual source point INTF is commonly referred to as the intermediate focus, and the source collector apparatus is arranged such that the intermediate focus INTF is located at or near an opening 219 in the enclosing structure 220. The virtual source point INTF is an image of the radiation emitting plasma 210. Grating spectral filter 240 is used in particular for suppressing infra-red (IR) radiation.

Subsequently the radiation traverses the illumination system IL, which can include a faceted field mirror device 222 and a faceted pupil mirror device 224 arranged to provide a desired angular distribution of the radiation beam 221, at the patterning device MA, as well as a desired uniformity of radiation intensity at the patterning device MA. Upon reflection of the beam of radiation 221 at the patterning device MA, held by the support structure MT, a patterned beam 226 is formed and the patterned beam 226 is imaged by the projection system PS via reflective elements 228, 229 onto a substrate W held by the wafer stage or substrate table WT.

More elements than shown can generally be present in illumination optics unit IL and projection system PS. The grating spectral filter 240 can optionally be present, depending upon the type of lithographic apparatus. Further, there can be more mirrors present than those shown in the FIG. 2, for example there can be one to six additional reflective elements present in the projection system PS than shown in FIG. 2.

Collector optic CO, as illustrated in FIG. 2, is depicted as a nested collector with grazing incidence reflectors 253, 254, and 255, just as an example of a collector (or collector mirror). The grazing incidence reflectors 253, 254, and 255 are disposed axially symmetric around an optical axis O and a collector optic CO of this type is preferably used in combination with a discharge produced plasma source, often called a DPP source.

### Exemplary Lithographic Cell

FIG. 3 shows a lithographic cell 300, also sometimes referred to a lithocell or cluster, according to some aspects. Lithographic apparatus 100 or 100' can form part of lithographic cell 300. Lithographic cell 300 can also include one or more apparatuses to perform pre- and post-exposure processes on a substrate. Conventionally these include spin coaters SC to deposit resist layers, developers DE to develop exposed resist, chill plates CH, and bake plates BK. A substrate handler, or robot, RO picks up substrates from input/output ports I/O1, I/O2, moves them between the different process apparatuses and delivers them to the loading bay LB of the lithographic apparatus 100 or 100'. These devices, which are often collectively referred to as the track, are under the control of a track control unit TCU, which is itself controlled by a supervisory control system SCS, which also controls the lithographic apparatus via lithography control unit LACU. Thus, the different apparatuses can be operated to maximize throughput and processing efficiency.

### Exemplary Inspection Apparatus

In order to control the lithographic process to place device features accurately on the substrate, alignment marks are generally provided on the substrate, and the lithographic apparatus includes one or more inspection apparatuses for accurate positioning of marks on a substrate. These alignment apparatuses are effectively position measuring apparatuses. Different types of marks and different types of alignment apparatuses and/or systems are known from different times and different manufacturers. A type of system widely used in current lithographic apparatus is based on a self-referencing interferometer as described in U.S. Patent No. 6,961,116 (den Boef et al.). Generally marks are measured separately to obtain X- and Y-positions. A combined X- and Y-measurement can be performed using the techniques described in U.S. Publication No. 2009/195768 A (Bijnen et al.), however.

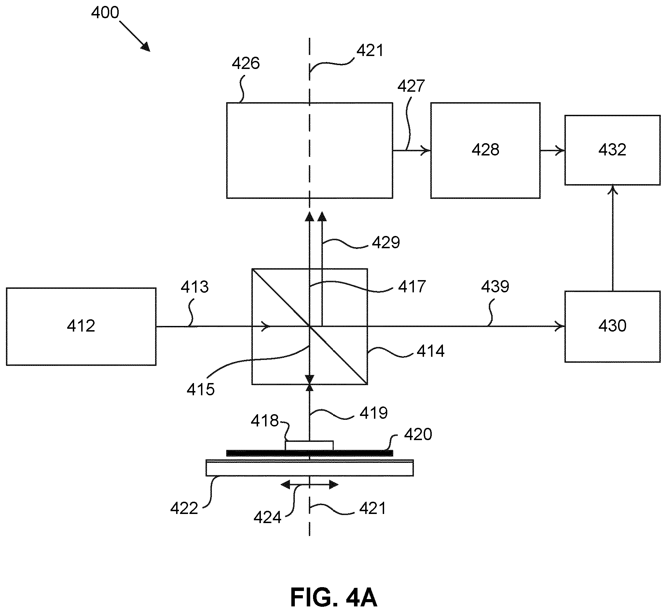

FIG. 4A shows a schematic of a cross-sectional view of an inspection apparatus 400 that can be implemented as a part of lithographic apparatus 100 or 100', according to some aspects. In some aspects, inspection apparatus 400 can be configured to align a substrate (e.g., substrate W) with respect to a patterning device (e.g., patterning device MA). Inspection apparatus 400 can be further configured to detect positions of alignment marks on the substrate and to align the substrate with respect to the patterning device or other components of lithographic apparatus 100 or 100' using the detected positions of the alignment marks. Such alignment of the substrate can ensure accurate exposure of one or more patterns on the substrate.

In some aspects, inspection apparatus 400 can include an illumination system 412, a beam splitter 414, an interferometer 426, a detector 428, a beam analyzer 430, and an overlay calculation processor 432. Illumination system 412 can be configured to provide an electromagnetic narrow band radiation beam 413 having one or more passbands. In an example, the one or more passbands can be within a spectrum of wavelengths between about 500 nm to about 900 nm. In another example, the one or more passbands can be discrete narrow passbands within a spectrum of wavelengths between about 500 nm to about 900 nm. Illumination system 412 can be further configured to provide one or more passbands having substantially constant center wavelength (CWL) values over a long period of time (e.g., over a lifetime of illumination system 412). Such configuration of illumination system 412 can help to prevent the shift of the actual CWL values from the desired CWL values, as discussed above, in current alignment systems. And, as a result, the use of constant CWL values can improve long-term stability and accuracy of alignment systems (e.g., inspection apparatus 400) compared to the current alignment apparatuses.

In some aspects, beam splitter 414 can be configured to receive radiation beam 413 and split radiation beam 413 into at least two radiation sub-beams. For example, radiation beam 413 can be split into radiation sub-beams 415 and 417, as shown in FIG. 4A. Beam splitter 414 can be further configured to direct radiation sub-beam 415 onto a substrate 420 placed on a stage 422. In one example, the stage 422 is movable along direction 424. Radiation sub-beam 415 can be configured to illuminate an alignment mark or a target 418 located on substrate 420. Alignment mark or target 418 can be coated with a radiation sensitive film. In some aspects, alignment mark or target 418 can have one hundred and eighty degrees (i.e., 180°) symmetry. That is, when alignment mark or target 418 is rotated 180° about an axis of symmetry perpendicular to a plane of alignment mark or target 418, rotated alignment mark or target 418 can be substantially identical to an unrotated alignment mark or target 418. The target 418 on substrate 420 can be (a) a resist layer grating comprising bars that are formed of solid resist lines, or (b) a product layer grating, or (c) a composite grating stack in an overlay target structure comprising a resist grating overlaid or interleaved on a product layer grating. The bars can alternatively be etched into the substrate. This pattern is sensitive to chromatic aberrations in the lithographic projection apparatus, particularly the projection system PL, and illumination symmetry and the presence of such aberrations will manifest themselves in a variation in the printed grating. One in-line method used in device manufacturing for measurements of line width, pitch, and critical dimension makes use of a technique known as "scatterometry". Methods of scatterometry are described in Raymond et al., "Multiparameter Grating Metrology Using Optical Scatterometry", J. Vac. Sci. Tech. B, Vol. 15, no. 2, pp. 361-368 (1997) and Niu et al., "Specular Spectroscopic Scatterometry in DUV Lithography", SPIE, Vol. 3677 (1999). In scatterometry, light is reflected by periodic structures in the target, and the resulting reflection spectrum at a given angle is detected. The structure giving rise to the reflection spectrum is reconstructed, e.g. using Rigorous Coupled-Wave Analysis (RCWA) or by comparison to a library of patterns derived by simulation. Accordingly, the scatterometry data of the printed gratings is used to reconstruct the gratings. The parameters of the grating, such as line widths and shapes, can be input to the reconstruction process, performed by processing unit PU, from knowledge of the printing step and/or other scatterometry processes.

In some aspects, beam splitter 414 can be further configured to receive diffraction radiation beam 419 and split diffraction radiation beam 419 into at least two radiation sub-beams, according to an aspect. Diffraction radiation beam 419 can be split into diffraction radiation sub-beams 429 and 439, as shown in FIG. 4A.

It should be noted that even though beam splitter 414 is shown to direct radiation sub-beam 415 towards alignment mark or target 418 and to direct diffracted radiation sub-beam 429 towards interferometer 426, the disclosure is not so limiting. It would be apparent to a person skilled in the relevant art that other optical arrangements can be used to obtain the similar result of illuminating alignment mark or target 418 on substrate 420 and detecting an image of alignment mark or target 418.

As illustrated in FIG. 4A, interferometer 426 can be configured to receive radiation sub-beam 417 and diffracted radiation sub-beam 429 through beam splitter 414. In an example aspect, diffracted radiation sub-beam 429 can be at least a portion of radiation sub-beam 415 that can be reflected from alignment mark or target 418. In an example of this aspect, interferometer 426 comprises any appropriate set of optical-elements, for example, a combination of prisms that can be configured to form two images of alignment mark or target 418 based on the received diffracted radiation sub-beam 429. It should be appreciated that a good quality image need not be formed, but that the features of alignment mark 418 should be resolved. Interferometer 426 can be further configured to rotate one of the two images with respect to the other of the two images 180° and recombine the rotated and unrotated images interferometrically.

In some aspects, detector 428 can be configured to receive the recombined image via interferometer signal 427 and detect interference as a result of the recombined image when alignment axis 421 of inspection apparatus 400 passes through a center of symmetry (not shown) of alignment mark or target 418. Such interference can be due to alignment mark or target 418 being 180° symmetrical, and the recombined image interfering constructively or destructively, according to an example aspect. Based on the detected interference, detector 428 can be further configured to determine a position of the center of symmetry of alignment mark or target 418 and consequently, detect a position of substrate 420. According to an example, alignment axis 421 can be aligned with an optical beam perpendicular to substrate 420 and passing through a center of image rotation interferometer 426. Detector 428 can be further configured to estimate the positions of alignment mark or target 418 by implementing sensor characteristics and interacting with wafer mark process variations.

In a further aspect, detector 428 determines the position of the center of symmetry of alignment mark or target 418 by performing one or more of the following measurements:
1. measuring position variations for various wavelengths (position shift between colors);
2. measuring position variations for various orders (position shift between diffraction orders); and
3. measuring position variations for various polarizations (position shift between polarizations).

This data can for example be obtained with any type of alignment sensor, for example a SMASH (SMart Alignment Sensor Hybrid) sensor, as described in U.S. Patent No. 6,961,116 that employs a self-referencing interferometer with a single detector and four different wavelengths, and extracts the alignment signal in software, or Athena (Advanced Technology using High order ENhancement of Alignment), as described in U.S. Patent No. 6,297,876, which directs each of seven diffraction orders to a dedicated detector

In some aspects, beam analyzer 430 can be configured to receive and determine an optical state of diffracted radiation sub-beam 439. The optical state can be a measure of beam wavelength, polarization, or beam profile. Beam analyzer 430 can be further configured to determine a position of stage 422 and correlate the position of stage 422 with the position of the center of symmetry of alignment mark or target 418. As such, the position of alignment mark or target 418 and, consequently, the position of substrate 420 can be accurately known with reference to stage 422. Alternatively, beam analyzer 430 can be configured to determine a position of inspection apparatus 400 or any other reference element such that the center of symmetry of alignment mark or target 418 can be known with reference to inspection apparatus 400 or any other reference element. Beam analyzer 430 can be a point or an imaging polarimeter with some form of wavelength-band selectivity. In some aspects, beam analyzer 430 can be directly integrated into inspection apparatus 400, or connected via fiber optics of several types: polarization preserving single mode, multimode, or imaging, according to other aspects.

In some aspects, beam analyzer 430 can be further configured to determine the overlay data between two patterns on substrate 420. One of these patterns can be a reference pattern on a reference layer. The other pattern can be an exposed pattern on an exposed layer. The reference layer can be an etched layer already present on substrate 420. The reference layer can be generated by a reference pattern exposed on the substrate by lithographic apparatus 100 and/or 100'. The exposed layer can be a resist layer exposed adjacent to the reference layer. The exposed layer can be generated by an exposure pattern exposed on substrate 420 by lithographic apparatus 100 or 100'. The exposed pattern on substrate 420 can correspond to a movement of substrate 420 by stage 422. In some aspects, the measured overlay data can also indicate an offset between the reference pattern and the exposure pattern. The measured overlay data can be used as calibration data to calibrate the exposure pattern exposed by lithographic apparatus 100 or 100', such that after the calibration, the offset between the exposed layer and the reference layer can be minimized.

In some aspects, beam analyzer 430 can be further configured to determine a model of the product stack profile of substrate 420, and can be configured to measure overlay, critical dimension, and focus of target 418 in a single measurement. The product stack profile contains information on the stacked product such as alignment mark, target 418, or substrate 420, and can include mark process variation-induced optical signature metrology that is a function of illumination variation. The product stack profile can also include product grating profile, mark stack profile, and mark asymmetry information. An example of beam analyzer 430 is Yieldstar^{™}, manufactured by ASML, Veldhoven, The Netherlands, as described in U.S. Patent No. 8, 706, 442. Beam analyzer 430 can be further configured to process information related to a particular property of an exposed pattern in that layer. For example, beam analyzer 430 can process an overlay parameter (an indication of the positioning accuracy of the layer with respect to a previous layer on the substrate or the positioning accuracy of the first layer with respective to marks on the substrate), a focus parameter, and/or a critical dimension parameter (e.g., line width and its variations) of the depicted image in the layer. Other parameters are image parameters relating to the quality of the depicted image of the exposed pattern.

In some aspects, an array of detectors (not shown) can be connected to beam analyzer 430, and allows the possibility of accurate stack profile detection as discussed below. For example, detector 428 can be an array of detectors. For the detector array, a number of options are possible: a bundle of multimode fibers, discrete pin detectors per channel, or CCD or CMOS (linear) arrays. The use of a bundle of multimode fibers enables any dissipating elements to be remotely located for stability reasons. Discrete PIN detectors offer a large dynamic range but each need separate pre-amps. The number of elements is therefore limited. CCD linear arrays offer many elements that can be read-out at high speed and are especially of interest if phase-stepping detection is used.

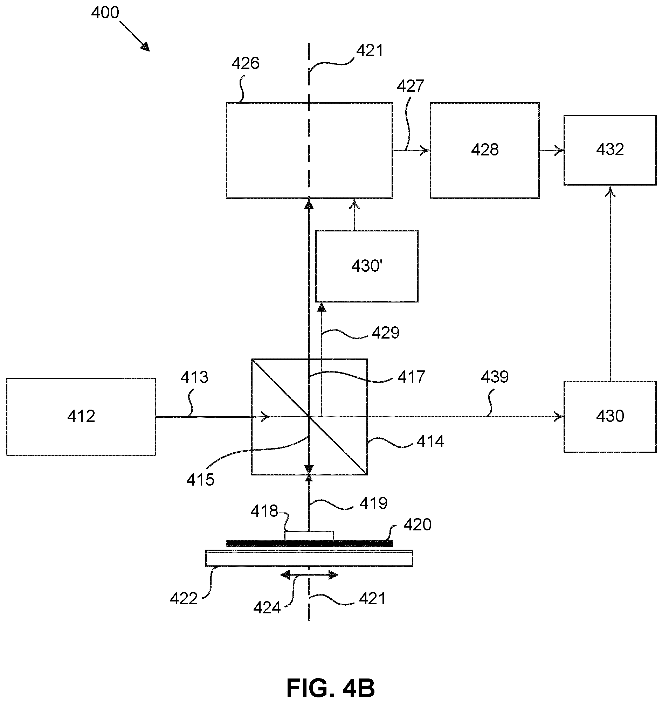

In some aspects, a second beam analyzer 430' can be configured to receive and determine an optical state of diffracted radiation sub-beam 429, as shown in FIG. 4B. The optical state can be a measure of beam wavelength, polarization, or beam profile. Second beam analyzer 430' can be identical to beam analyzer 430. Alternatively, second beam analyzer 430' can be configured to perform at least all the functions of beam analyzer 430, such as determining a position of stage 422 and correlating the position of stage 422 with the position of the center of symmetry of alignment mark or target 418. As such, the position of alignment mark or target 418 and, consequently, the position of substrate 420, can be accurately known with reference to stage 422. Second beam analyzer 430' can also be configured to determine a position of inspection apparatus 400, or any other reference element, such that the center of symmetry of alignment mark or target 418 can be known with reference to inspection apparatus 400, or any other reference element. Second beam analyzer 430' can be further configured to determine the overlay data between two patterns and a model of the product stack profile of substrate 420. Second beam analyzer 430' can also be configured to measure overlay, critical dimension, and focus of target 418 in a single measurement.

In some aspects, second beam analyzer 430' can be directly integrated into inspection apparatus 400, or it can be connected via fiber optics of several types: polarization preserving single mode, multimode, or imaging, according to other aspects. Alternatively, second beam analyzer 430' and beam analyzer 430 can be combined to form a single analyzer (not shown) configured to receive and determine the optical states of both diffracted radiation sub-beams 429 and 439.

In some aspects, processor 432 receives information from detector 428 and beam analyzer 430. For example, processor 432 can be an overlay calculation processor. The information can comprise a model of the product stack profile constructed by beam analyzer 430. Alternatively, processor 432 can construct a model of the product mark profile using the received information about the product mark. In either case, processor 432 constructs a model of the stacked product and overlay mark profile using or incorporating a model of the product mark profile. The stack model is then used to determine the overlay offset and minimizes the spectral effect on the overlay offset measurement. Processor 432 can create a basic correction algorithm based on the information received from detector 428 and beam analyzer 430, including but not limited to the optical state of the illumination beam, the alignment signals, associated position estimates, and the optical state in the pupil, image, and additional planes. The pupil plane is the plane in which the radial position of radiation defines the angle of incidence and the angular position defines the azimuth angle of the radiation. Processor 432 can utilize the basic correction algorithm to characterize the inspection apparatus 400 with reference to wafer marks and/or alignment marks 418.

In some aspects, processor 432 can be further configured to determine printed pattern position offset error with respect to the sensor estimate for each mark based on the information received from detector 428 and beam analyzer 430. The information includes but is not limited to the product stack profile, measurements of overlay, critical dimension, and focus of each alignment marks or target 418 on substrate 420. Processor 432 can utilize a clustering algorithm to group the marks into sets of similar constant offset error, and create an alignment error offset correction table based on the information. The clustering algorithm can be based on overlay measurement, the position estimates, and additional optical stack process information associated with each set of offset errors. The overlay is calculated for a number of different marks, for example, overlay targets having a positive and a negative bias around a programmed overlay offset. The target that measures the smallest overlay is taken as reference (as it is measured with the best accuracy). From this measured small overlay, and the known programmed overlay of its corresponding target, the overlay error can be deduced. Table 1 illustrates how this can be performed. The smallest measured overlay in the example shown is -1 nm. However this is in relation to a target with a programmed overlay of -30 nm. The process can have introduced an overlay error of 29 nm.

| Table 1 | | | | | | | |
|---|---|---|---|---|---|---|---|
| Programmed overlay | -70 | -50 | -30 | -10 | 10 | 30 | 50 |
| Measured overlay | -38 | -19 | -1 | 21 | 43 | 66 | 90 |
| Difference between measured and programmed overlay | 32 | 31 | 29 | 31 | 33 | 36 | 40 |
| Overlay error | 3 | 2 | - | 2 | 4 | 7 | 11 |

The smallest value can be taken to be the reference point and, relative to this, the offset can be calculated between measured overlay and that expected due to the programmed overlay. This offset determines the overlay error for each mark or the sets of marks with similar offsets. Therefore, in the Table 1 example, the smallest measured overlay was -1 nm, at the target position with programmed overlay of 30 nm. The difference between the expected and measured overlay at the other targets is compared to this reference. A table such as Table 1 can also be obtained from marks and target 418 under different illumination settings, the illumination setting, which results in the smallest overlay error, and its corresponding calibration factor, can be determined and selected. Following this, processor 432 can group marks into sets of similar overlay error. The criteria for grouping marks can be adjusted based on different process controls, for example, different error tolerances for different processes.

In some aspects, processor 432 can confirm that all or most members of the group have similar offset errors, and apply an individual offset correction from the clustering algorithm to each mark, based on its additional optical stack metrology. Processor 432 can determine corrections for each mark and feed the corrections back to lithographic apparatus 100 or 100' for correcting errors in the overlay, for example, by feeding corrections into the inspection apparatus 400.

### Exemplary Actuated Stage

In some aspects, the term "throughput" can be used to describe the rate at which a wafer clears a particular fabrication step and moves to the next step. Throughput can be a performance marker of marketability of a lithographic system. It is desirable for lithographic systems to output as many products as possible in as little time as possible. Lithographic fabrication can comprise several complex fabrication processes. Each fabrication process has technical features that balance desired fabrication qualities and drawbacks (e.g., sub-nanometer accuracy, high yield per wafer, high throughput, or the like, versus slower fabrication, printing errors, cost, or the like).

In a lithographic apparatus (or an inspection apparatus), a wafer or reticle is able to scan in a given direction at a given speed. Wafers and reticles can be supported on a chuck, with the chuck being on a fast-moving stage. However, forces from high acceleration can cause the chuck to warp (e.g., elongate), which can cause a positioning error of the wafer or reticle. The positioning error can result in printing errors of devices being fabricated from the wafers.

Aspects disclosed herein include devices and functions to address structural issues of moving stages with negligible compromise in terms of space requirements, complexity, and cost.

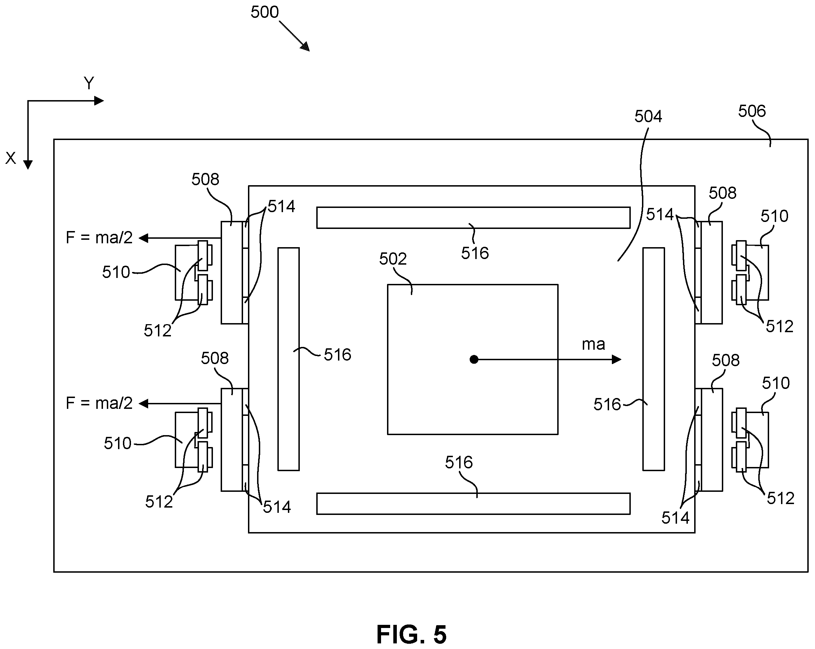

FIG. 5 shows a stage 500 for supporting an object 502, according to some aspects. In some aspects, stage 500 can comprise a support structure 504 (e.g., a first support structure), a support structure 506 (e.g., a second support structure), actuator devices 510, and actuator targets 508. Actuator devices 510 can comprise coil windings 512. Actuator target 508 can be disposed and affixed on support structure 504 using affixing structures 514 (e.g., epoxy). The number and configuration of actuator-related elements are not limited to those shown in FIG. 5. Fewer or more actuator-related elements can be used, as well as other configurations. Stage 500 can also comprise one or more positional indicators 516 (e.g., encoder scales).

It should be appreciated that, in some aspects, enumerative adjectives (e.g., "first," "second," "third," or the like) can be used as a naming convention and are not intended to indicate an order or hierarchy (unless otherwise noted). For example, the terms "a first support structure" and "a second support structure" can distinguish two support structures, but need not specify if the support structures have a particular order or hierarchy. Furthermore, an element in a drawing is not limited to any particular enumerative adjective. For example, one actuator device 510 can be referred to as a second actuator device if other actuator device(s) use appropriately distinguishing enumerative adjective(s). In another non-limiting example, one can choose to name the upper right actuator device 510 as a first actuator device and then identify the remaining actuator devices as second, third, and fourth going clockwise, counterclockwise, in a cross pattern, or the like.

In some aspects, stage 500 can be used in lithographic apparatuses 100 or 100' (FIGS. 1A, 1B, and 2), lithographic cell 300 (FIG. 3), inspection apparatus 400 (FIGS. 4A and 4B), or any apparatus in general that has a stage implementation for supporting and moving an object. For example, stage 500 can show a specific implementation of wafer table WT or mask table MT (FIGS. 1A, 1B, and 2), or stage 422 (FIGS. 4A and 4B).

In some aspects, support structure 506 can be an actuated structure (e.g., for coarse motion of object 502). In a lithographic fabrication process, object 502 can be a semiconductor wafer that is, e.g., 300 mm in diameter (this is a non-limiting example as those skilled in the art will appreciate that wafers are commercially available in different sizes). Furthermore, stage 500 can also include additional movement budget to shuttle object 502 to and from a loading area. Therefore, support structure 506 can be responsible for a coarse motion of stage 500, e.g., in the order of tens, hundreds, or thousands of millimeters. Other distances can be chosen based on suitability for a particular implementation. However, in implementations where coarse motion is not needed, support structure 506 can be a static frame.

In some aspects, support structure 504 can be supported by support structure 506 while also allowing relative movement between the two support structures. The motion of support structure 504 can be limited to an axis (e.g., Y-axis) using guide rails or a contactless method (e.g., magnetic levitation) (guide devices not shown). Actuator devices 510 can be responsible for fine adjustments of a position of support structure 504. Therefore, some aspects use a small gap between actuator devices 510 and their corresponding actuator targets 508. For example, a gap can be a few millimeters or less (e.g., less than approximately 1 mm). In a scanning lithographic process, printed devices can have critical dimensions in the sub-micron or sub-nanometer range. A movement budget of a millimeter can be large enough for scan-printing of sub-nanometer devices.

In some aspects, actuator devices 510 can be disposed and affixed on support structure 506. Actuator devices 510 can actuate support structure 504 by interacting with actuator targets 508. Actuator targets 508 can comprise a material that responds to magnetic fields (e.g., a metal, iron, ferrite, or the like). Actuator devices 510 can be electromagnets. The electromagnets can generate and adjust magnetic fields. An electromagnet can comprise coils 512 of wire wrapped around a metal core (e.g., a ferrite core). Actuator devices 510 can operate as attract-only if actuator targets 508 are not permanent magnets. Conversely, actuator devices 510 can repel and attract a permanent-magnet version of actuator target 508 by reversing a direction of the magnetic field. The actuator setup described herein can be referred to by other terms of art (e.g., a reluctance actuator; and it follows that actuator target 508 can be referred to as a reluctance target).

In some aspects, actuator devices 510 can actuate support structure 504 using a high acceleration. The acceleration can be, for example, approximately 4-100g, 10-50g, 20-40g, or the like (where g is 9.8 m/s²). A high acceleration can increase lithographic print production (e.g., increase throughput). Lithographic pattern transfer can be performed when support structure 504 is in motion, for example, when it reaches a constant coasting speed. Coasting speeds can be, for example, 0.5-10.0 m/s, 1.0-7.0 m/s, 3.0-5.0 m/s, or the like. Performing the pattern transfer at a constant scanning speed can result in more accurate transfers of the printed pattern, whereas printing during acceleration can be accompanied by larger positional uncertainties.

In some aspects, the nature of magnetic fields can be that a repulsive interaction is unstable and can create undesirable side forces (orthogonal to the direction of repulsion) and undesirable orthogonal torques. The orthogonal forces/torques tend to move the magnets in such a way as to change the interaction from repulsive to attractive, in order to minimize the total potential energy of the magnet set. Without external lateral guidance or constraining forces the arrangement is unstable and jumps to the closest stable equilibrium position, with gaps closing (no longer levitating). Consequently, repulsion systems using permanent magnets can be challenging to engineer and can prompt the addition of active controls to keep the arrangement from collapsing, or external mechanical guides. The additional complexity of lithographic systems can significantly increase engineering difficulty. Therefore, in some aspects, actuator devices 510 can be designed to operate using attraction only (or pull-only). With actuator devices 510 at opposite sides of support structure 504, it is possible to impart both forward and backward motion to support structure 504 while using a pull-only configuration. However, a pull-only method can have certain drawbacks, as will be discussed further below.

In some aspects, object 502 can be temporarily affixed onto support structure 504 by pressing object 502 onto support structure 504. This can be accomplished by vacuum clamping (suction force), electrostatic clamping (electrostatic force), mechanical clamping, or the like. Under ideal conditions, mutual friction between object 502 (e.g., a reticle) and support structure 504 (e.g., a chuck) can ensure that there is no slippage therebetween. However, mechanical stresses due to high accelerations can induce some slippage, resulting in printing error. The errors can be highly detrimental due to the possibility of losing thousands of device products by the time the error can be detected.

The following is an example of a positioning error of object 502 when using stage 500. In some aspects, object 502 can be affixed onto support structure 504. In order to determine a position of features on object 502, a calibration measurement can be performed using, for example, an optical inspection system. The calibration measurement can determine the position of features on object 502 relative to one or more positional indicators 516. Positional indicators 516 can be rigidly affixed to support structure 504. With the relationship between object 502 and one or more positional indicators 516 established, object 502 can be used for high precision processes (e.g., lithographic processes) and the calibration need not be carried out again so long as object 502 remains stationary with respect to support structure 504. Conversely, any relative motion between object 502 and support structure 504 can be considered a positioning error-an error that subsequently gets transferred onto every process after the occurrence of the error event.

The following is an example of conditions and mechanisms that can induce a positioning error. In some aspects, an electromagnetic force can be applied by actuator devices 510 on actuator targets 508. For example, actuator devices 510 on the left side of support structure 504 can be activated, which then pull on the corresponding actuators 508, affixing structures 514, and finally support structure 504. It follows that actuator devices 510 on the right side of support structure 504 can be used to pull in the opposite direction (for deceleration) and allow support structure 504 to come to rest. During acceleration/deceleration, the combined mass of object 502 and support structure 504 are inertial, and they exert a force that is equal and opposite to the force exerted by actuator targets 508 during the pulling (drawn as the arrow "ma" (mass×acceleration) pointed to the right). Conversely, if two actuator targets 508 are doing the pulling, then the pulling force can be split between the two actuator targets 508 (drawn as two arrows "F=ma/2").

A drawback of the pull-only scheme is that, in some aspects, support structure 504 can be under a high tension gradient due to the high acceleration (e.g., 4-100g). The tension can cause support structure 504 to deform (e.g., elongate). Even if support structure 504 is made of a rigid construction (e.g., made of glass and ribbed reinforcement), a deformation of even a few picometers can cause object 502 to shift a few picometers relative to one or more positional indicators 516, thereby introducing positioning error. Though a pull-push scheme (some actuator devices 510 pulling and some pushing from behind) would counteract much of the tension and deformation issue, it would also introduce the issues described above regarding magnet repulsion.

Another drawback of the pull-only scheme is that, in some aspects, affixing structures 514 can also be under significant tension due to the high acceleration. In the non-limiting example in which affixing structures 514 are made of epoxy, epoxy under tension-only can creep (e.g., stretch out slowly over time), compounding the probability of mechanical failure when compared to a pull-push scheme in which epoxy stress averages to zero (e.g., under tension when pulling in one direction, but also under compression when pushing in the opposite direction).

Some aspects described herein provide structures and functions to address issues of a pull-only scheme.

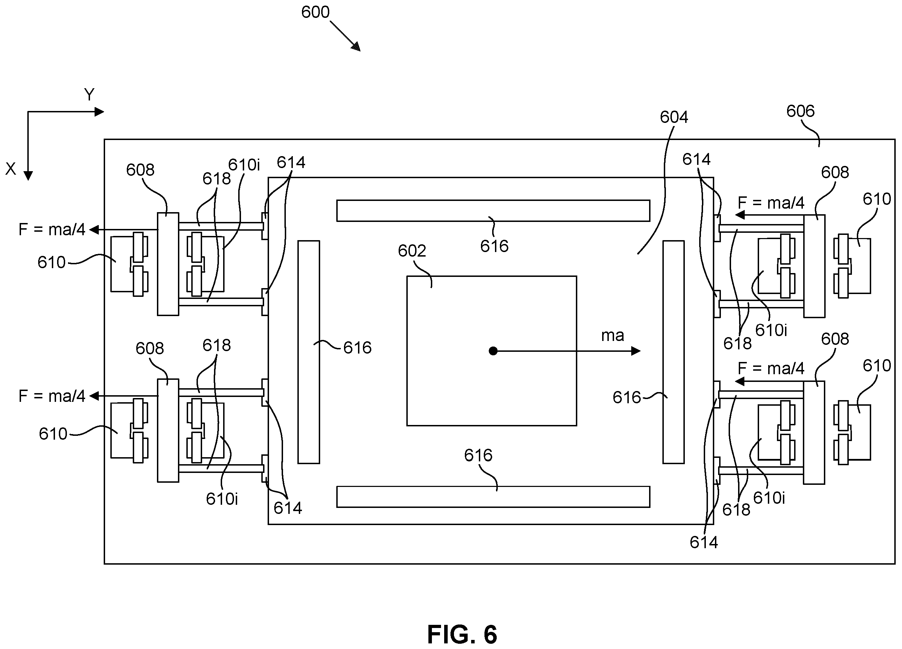

FIG. 6 shows a stage 600 for supporting an object 602, according to some aspects. In some aspects, stage 600 can have some features that were already described in reference to FIG. 5. Compared to FIG. 6, additional elements may be shown while some may be hidden (for clarity purposes). Unless otherwise noted, structures and functions described previously for elements of FIG. 5 can also apply to similarly numbered elements of FIG. 6 (e.g., reference numbers sharing the two right-most numeric digits). At least some structures and functions of elements of FIG. 6 should be apparent from descriptions of corresponding elements of FIG. 5 and will not be reintroduced.

In some aspects, in addition to features of stage 500 (FIG. 5), stage 600 can also comprise additional interior actuator devices 610i and extension structures 618 (e.g., cantilevers). As with actuator devices 610, interior actuator devices 610i can be disposed and affixed on support structure 606. Extension structures 618 can be used to structurally affix actuator targets 608 at a distance from the sides of support structure 604 with the aid of affixing structures 614 (e.g., epoxy). With the space created by extension structures 618, a given one of actuator devices 610i can be disposed in the interior space defined by its corresponding actuator target 608, its corresponding extension structures 618, and the side of support structure 604 (as shown in FIG. 6).

In some aspects, the configuration of stage 600 can be used to cure at least some of the issues described above for stage 500 (FIG. 6). For example, while the two actuators devices 610 on the left to pull support structure 604, another two internal actuator devices 610i on the right of support structure 604 can be used to "push" support structure 604. The four activated actuator devices are denoted with four arrows labeled "F=ma/4," as the total force is divided up amongst their corresponding four actuator targets 608 (fewer or more actuator devices can be implemented). However, the right two actuator devices 610i use attraction (pulling) to move support structure 604 to the left, and therefore it can be said that the scheme of FIG. 6 is a pull-pull scheme. As a result, the issues of repulsion described above can be avoided while also reducing the deformation of support structure 604 and balancing the stress on affixing structures 614 (i.e., zero average stress from balancing tension and compression from moving forward and backward). To decelerate and/or reverse a direction of motion, the corresponding actuator devices 610 and internal actuator devices 610i can be used in a pull-pull configuration.

In some aspects, the addition of internal actuator devices 610i and extension structures 618 can have some undesirable consequences. One drawback is that cost of construction is increased (additional parts and manufacturing complexity). Another drawback is that overall weight is increased on moving components, adding to their inertia. In FIG. 6, the mass of the coarse motion structure (support structure 606 and everything it supports) has increased due to the four additional heavy electromagnets (internal actuator devices 610i). The mass of the fine (support structure 606 and everything it supports) has increased due to the addition of extension structures 618. Furthermore, extension structures 618 can be sensitive to vibrations, resulting in poorer dynamics in the motion of support structure 604. Additional uncertainties due to vibrations affect pattern transfer accuracy when object 602 is used as a reticle for lithographic processes.

Some aspects described herein provide structures and functions to address issues of both the pull-only scheme and the pull-pull scheme.

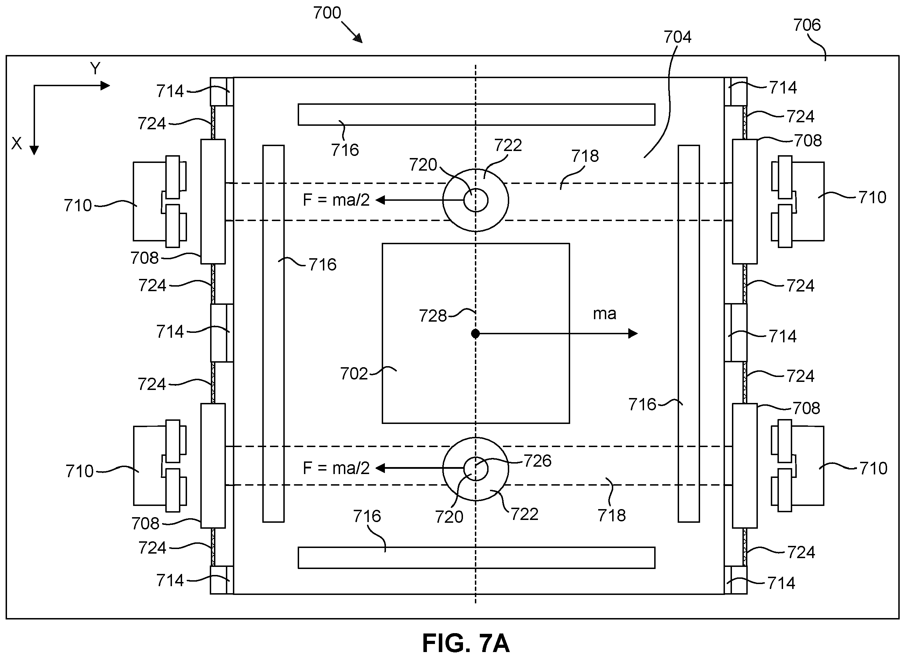

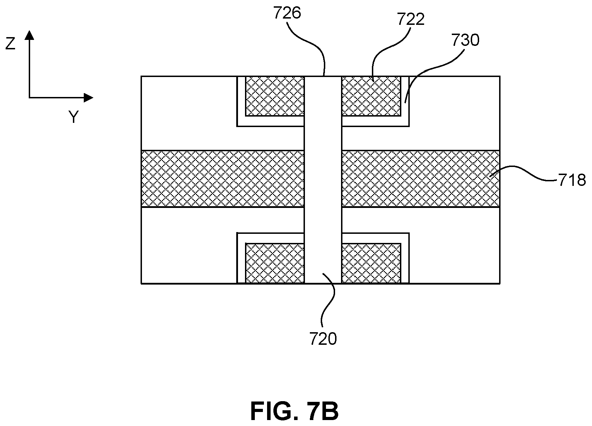

FIGS. 7A and 7B show a stage 700 for supporting an object 702, according to some aspects. In some aspects, stage 700 can have some features that were already described in reference to FIGS. 5 and 6. Compared to FIGS. 5 and 6, additional elements may be shown while some may be hidden (for clarity purposes). Unless otherwise noted, structures and functions described previously for elements of FIGS. 5 and 6 can also apply to similarly numbered elements of FIGS. 7A and 7B (e.g., reference numbers sharing the two right-most numeric digits). At least some structures and functions of elements of FIGS. 7A and 7B should be apparent from descriptions of corresponding elements of FIGS. 5 and 6 and will not be reintroduced.

Referring to FIG. 7A, in some aspects, in addition to features of stages 500 or 600 (FIGS. 5 and 6) (or instead of certain features), stage 700 can comprise a shaft 718. Shaft 718 can affixed to support structure 704 using a fastener 720 (e.g., a pin, a bolt, or the like). One or more load spreader 722 can be used to surround a portion of fastener 720. One or more of actuator targets 708 can be affixed to shaft 718 (e.g., one actuator target 708 at each end of the shaft) (affixing can be achieved via welding, glue, epoxy, or the like). Actuator targets 708 can be coupled to one or more stabilizers 724. The shaft implementation can be iterated so as to have more than one shaft and corresponding attached elements, as shown in FIG. 7A.

In some aspects, shaft 718 can be affixed to support structure 704 at a location 726 of support structure 704. Location 726 can be approximately along a center line 728 of support structure 704 (e.g., a center line that bisects the support structure). When the corresponding actuator device 710 is activated to pull on actuator target 708, shaft 718 can transmit the mechanical load from actuator target 708 to location 726 of support structure 704. By distributing the mechanical load in this manner, the high tension gradient of stage 500 (FIG. 5) can be reduced. Instead, the distortion effects can be divided into a compressive region to the left of location 726 (assuming a pulling force directed to the left) and a tensional region to the right of location 726. Due to the reconfigured compressive and tensional stresses of support structure 704, the risk of object 702 experiencing slippage can be significantly reduced. Furthermore, having two actuator targets 708 affixed to opposite ends of the same shaft 718, the mechanical load can be distributed more evenly. For example, as one actuator target is pulled to the left, a portion of the mechanical load transmitted by the shaft is transmitted to the trailing actuator target. The force exerted by the trailing actuator can push support structure 704, thereby counteracting the inertial tendency of the chuck to elongate as well as zeroing the average stress in the epoxy a large number of scanning cycles.

FIG. 7B, shows a cross-section of location 726 of support structure 704, according to some aspects. In some aspects, shaft 718 can run through an interior of support structure 704. However, other implementations are envisaged, such as having shaft 718 being attached at an exterior of support structure 704 (e.g., referring to orientations on the page of FIG. 7A, top edge of support structure 704, bottom edge of support structure 704, in a recess on a surface of support structure 704, or the like). Support structure 704 can comprise a hole at location 726. Shaft 718 can also comprise a hole that aligns with the hole of support structure 704. Fastener 720 can be disposed in the holes of both support structure 704 and shaft 718 to affix the shaft at location 726.

In some aspects, support structure 704 can comprise one or more counterbore that aligns with the hole at location 726. Load spreaders 722 can be disposed in each counterbore and surrounding fastener 720 to spread a mechanical load during acceleration. Load spreaders 722 can comprise, for example, diaphragm flexures. One or more load spreaders 722 can be affixed at the countersink using an adhesive structure 730 (epoxy). Considering the motion of support structure 704 (e.g., scanned back and forth, left and right), the stresses on the epoxy have a balance of compression and tension, which addresses the issues of tension imbalance on the epoxies used in stage 500 (FIG. 5). In some aspects, the design can be such that a clearance hole surrounds fastener 720 (not shown) such that no direct contact occurs between fastener 720 and the support structure 704.

Referring back to FIG. 7A, in some aspects, the features of stage 700 can achieve certain desirable features of stages 500 and 600 while mitigating the above-noted drawbacks. For example, the setup of stage 700 allows reduction of parts and footprint when compared to stage 600 (FIG. 6). Consequently, there is cost, weight, and space reduction by eliminating a need for using additional internal actuator devices 610i and extension structure 618 (FIG. 6). While stage 500 used fewer actuator devices 510 (FIG. 5) than stage 600 (FIG. 6) and had issues of high tension and deformation, stage 700 can mitigate tension deformation without needing to increase the actuator device count.

In some aspects, stage 700 can implement low-mass solutions to further enhance the dynamics of stage 700. For example, stabilizers 724 can be used to reduce the effects of vibration. Stabilizers 724 can be coupled to actuator targets 708. Stabilizers 724 can comprise flexures.

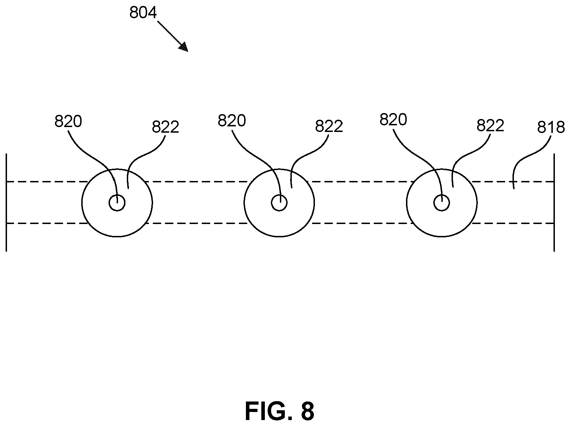

FIG. 8 shows a section of a support structure 804, according to some aspects. In some aspects, support structure 804 can have an alternative shaft implementation as compared with support structure 704 (FIG. 7). It is to be appreciated that certain features of support structure 704 are not shown for drawing clarity. However, further features of support structure 804 should be apparent from descriptions of FIGS. 5-7 and will not be reintroduced.

In some aspects, a shaft 818 can be used to transfer a load from an actuator target (e.g., 708 (FIG. 7)) to a plurality of locations of support structure 804. Support structure 804 can comprise first, second, and/or third holes at corresponding first, second, and/or third locations of support structure 804. Shaft 818 can also comprise first, second, and/or third holes that align with the corresponding holes of support structure 804. Fasteners 820 can be disposed in the holes of both support structure 804 and shaft 818 to affix the shaft at the first, second, and/or third locations of support structure 804. A diameter of fasteners 820 can be smaller than a diameter of fastener 720 (FIG. 7) owing to the distributing of the loads across a plurality of fasteners, as opposed to placing all the load on a single fastener 720 (FIG. 7).

### Exemplary Actuated Stage with Tensional Member

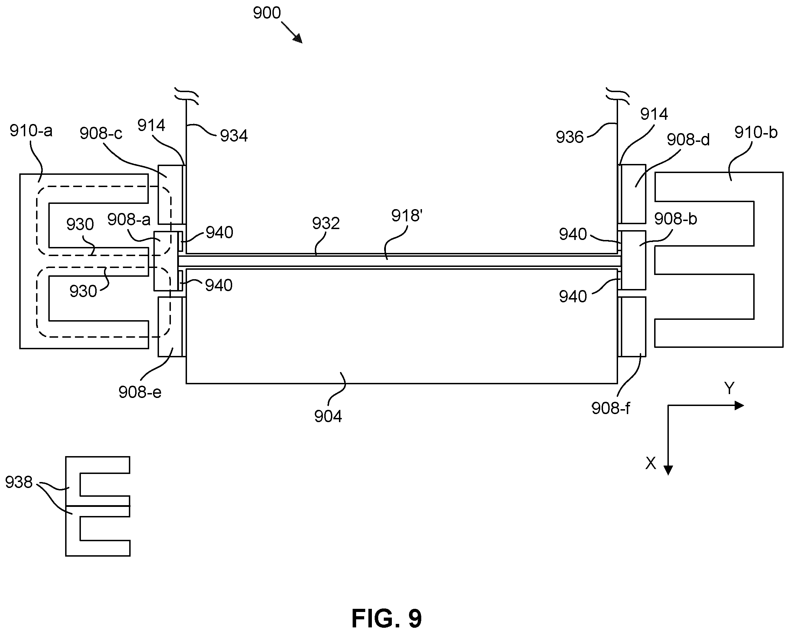

FIG. 9 shows a portion of a stage 900 for supporting an object (e.g., a wafer, reticle, or the like), according to some aspects. In some aspects, stage 900 can have some features that were already described in reference to FIGS. 5-8. Compared to FIGS. 5-8, additional elements may be shown while some may be hidden (for clarity purposes). Unless otherwise noted, structures and functions described previously for elements of FIGS. 5-8 can also apply to similarly numbered elements of FIG. 9 (e.g., reference numbers sharing the two right-most numeric digits). At least some structures and functions of elements of FIG. 9 should be apparent from descriptions of corresponding elements of FIG. 5-8.

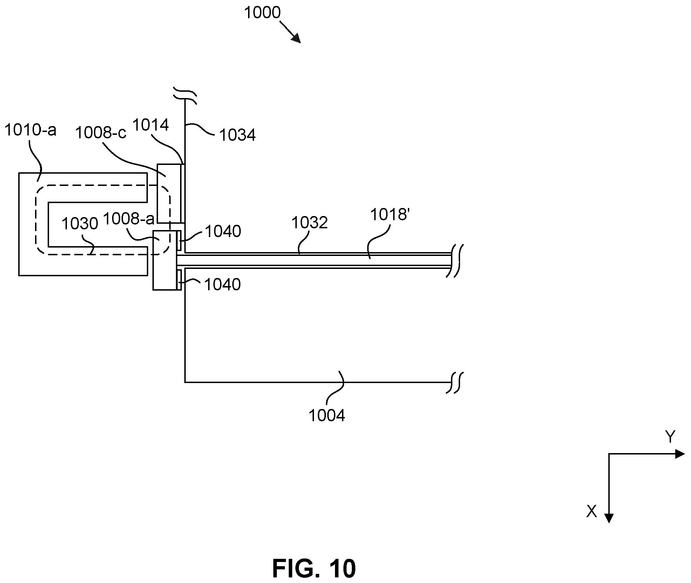

In some aspects, stage 900 can comprise a support structure 904, actuator targets 908 (e.g., three or more), one or more actuator devices 910, and a tensional member 918'. Support structure can be a chuck that rests on another support structure (e.g., support structure 706 FIGS. 7A and 7B). By non-limiting example, actuator devices 910-a and 910-b are shown as E-shaped cores of electromagnets. Other types of electromagnetic cores are also envisaged. For example, some aspects referencing the C-shaped cores in FIG. 10 are disclosed herein. Wire coils are not explicitly shown in FIG. 9, but their presence and function should be apparent to those skilled in the art based on descriptions of prior figures (e.g., coil windings 512 (FIG. 5)), as well as magnetic fields 930. Tensional member 918' can be a slack or flexible material (e.g., a cord), a rigid rod (e.g., shaft 718 (FIGS. 7A and 7B), or the like.

In some aspects, support structure 904 can comprise a hollowed portion 932 (e.g., a groove or channel). Tensional member 918' is disposed in hollowed portion 932. A dimension (e.g., cross-section, diameter, or the like) of hollowed portion 932 can be larger than a dimension of tensional member 918' so as to allow tensional member 918' to move within hollowed portion 932. Hollowed portion 932 can be implemented in a number of different ways (e.g., as a hollowed channel, a groove on an exterior of support structure 904, one or more rings, or the like). Actuator targets 908-a, 908-b, 908-c, 908-d, 908-e, and 908-f are explicitly shown (e.g., first actuator target, second actuator target, another actuator target, or the like). But it should be appreciated that more or fewer actuator targets can be implemented.

In some aspects, actuator device 910-a and actuator targets 908-a, 908-c, and 908-e can be disposed at side 934 (e.g., a first side) of support structure 904. Actuator device 910-a can be disposed proximal to actuator targets 908-a, 908-c, and 908-e (e.g., so that the electromagnet can attract the actuator targets when the electromagnet is turned on). Actuator device 910-b and actuator targets 908-b, 908-d, and 908-f can be disposed at side 936 (e.g., a second side) of support structure 904 that is opposite of side 934. Actuator device 910-b can be disposed proximal to actuator targets 908-b, 908-d, and 908-f.

In some aspects, for E-shaped cores, the first, second, and third structural projections of the E-shaped core can be disposed facing respective actuator targets. C-shaped cores can be arranged the similarly (e.g., instead of three projections, two projections facing two actuator targets). An E-shaped core can be constructed from a single block of magnetically permeable material or an assembly of two or more parts (e.g., two C-shaped cores 938 attached to one another).

In some aspects, actuator targets 908-c and 908-e can be attached to side 934 of support structure 904. The attaching can be achieved using, for example, adhesive structure 914 (e.g., an adhesive such as epoxy). Actuator targets 908-a and 908-b can be attached at opposite ends of tensional member 918'. When, for example, actuator device 910-a is turned on to generate magnetic fields 930 at side 934 of support structure 904, the magnetic interaction can attract actuator targets 908-a, 908-c- and 908-e in order to move support structure 904 along a given direction. Furthermore, tensional member 918' can transmit a mechanical load to side 936 of support structure 904 via actuator target 908-b (e.g., mechanical load transference is based on a magnetic force exerted on the first actuator target).

In some aspects, a dimension (e.g., a cross section, diameter) of targets 908-a and 908-b can be larger than a dimension of hollowed portion 932 such that targets 908-a and 908-b are unable to enter hollowed portion 932. In this scenario, by pulling on target 908-a using magnetic fields 930, target 908-b can "hook" onto side 936, thereby allowing for pushing motion of support structure 904 to supplement the pulling motion occurring at side 934 via targets 908-c and 908-e. In this manner, the acceleration and speed of support structure 904 can be increased, as well as reducing undesirable effects of solely pulling from one side of the support structure, as explained above in reference to previous figures (e.g., deformation).

In some aspects, actuator target 908-b can comprise a load spreader 940 to spread the mechanical load being transferred to side 936. Actuator target 908-a can also comprise a load spreader 940. Load spreaders 940 can comprise, for example, soft pads, coil springs, flexures, collapsible structures, or the like.

In some aspects, a separation gap between actuator targets 908-a and 908-c can be small in order to prevent attenuation of magnetic field 930. In particular, the gap between adjacent actuator targets can be much smaller than the operating gap between an actuator target (e.g., 908-a) and the poles of an actuator device (e.g., 910-a). In a non-limiting example, much smaller can be 20% or less, 15% or less, 10% or less, 5% or less, 20% to 5%, 15% to 5%, 15% to 10%, 10% to 5%, or the like. When such a condition is imposed, the flux reduction caused by the gaps between actuator targets can be negligible compared to the flux reduction caused by the operating gap between the actuator device and the actuator targets (e.g., negligible can be less than a few percent impact to the generated force per unit current through the coils).

In some aspects, an operating gap between the actuator device and the actuator targets can be 1500 microns or less, 1000 microns or less, 500 microns or less, or the like. Using 500 microns operating gap and a 10% or less constraint as a non-limiting example, a 50 micron gap between two actuator targets can be considered negligible. On the other hand, there can be manufacturability issues that can prevent such a small gap from being practical or economical to produce. But outside practicality considerations, the smaller the gap is, the better the performance of the actuation (e.g., force divided by the current in the coils).

In some aspects, if reduced manufacturing cost is preferred over high performance, a gap of 200 microns or less can be desirable for its more lax tolerance (arguably easier to make). A trade off can be that it uses more current and it can also worsen heating for the same output force. There are also thermal expansion considerations. It is desirable to minimize heat generation by the actuator device by maximizing its electromagnetic performance. The separation gap between adjacent actuator targets 908-a and 908-c can be, for example, approximately 2 mm or less, 1 mm or less, 500 microns or less, 200 microns or less, 100 microns or less, 50 microns or less, 20 microns or less, or 10 microns or less. This feature for the separation can be extended to the gaps between actuator targets 908-a and 908-e, 908-b and 908-d, and 908-b and 908-f.

It is to be appreciated that, in some aspects, the functions described above for moving support structure 904 toward the left of the figure (e.g., a first direction) can inversely apply to actuator device 910-b and actuator targets 908-b, 908-d, and 908-f for movement in the opposite direction.

FIG. 10 shows a portion of a stage 1000 for supporting an object (e.g., a wafer, reticle, or the like), according to some aspects. In some aspects, stage 1000 can have some features that were already described in reference to FIGS. 5-9. Compared to FIGS. 5-9, additional elements may be shown while some may be hidden (for clarity purposes). Unless otherwise noted, structures and functions described previously for elements of FIGS. 5-9 can also apply to similarly numbered elements of FIG. 10 (e.g., reference numbers sharing the two right-most numeric digits). At least some structures and functions of elements of FIG. 10 should be apparent from descriptions of corresponding elements of FIG. 5-9.

In some aspects, actuator device 1010-a can be a C-shaped core. Actuator targets 1008-a and 1008-c can be disposed proximal to the poles of actuator device 1010-a. The structures and/or functions of other elements appearing in FIG. 10 can be as explained above in reference to prior figures (e.g., support structure 1004, adhesive structure 1014, tensional member 1018', magnetic field 1030, hollowed portion 1032, side 1034, and/or load spreaders 1040).

Although specific reference can be made in this text to the use of lithographic apparatus in the manufacture of ICs, it should be understood that the lithographic apparatus described herein can have other applications, such as the manufacture of integrated optical systems, guidance and detection patterns for magnetic domain memories, flat-panel displays, LCDs, thin-film magnetic heads, etc. The skilled artisan will appreciate that, in the context of such alternative applications, any use of the terms "wafer" or "die" herein can be considered as specific examples of the more general terms "substrate" or "target portion", respectively. The substrate referred to herein can be processed, before or after exposure, in for example a track unit (a tool that typically applies a layer of resist to a substrate and develops the exposed resist) and/or a metrology unit. Where applicable, the disclosure herein can be applied to such and other substrate processing tools. Further, the substrate can be processed more than once, for example in order to create a multi-layer IC, so that the term substrate used herein can also refer to a substrate that already contains multiple processed layers.

Although specific reference can have been made above to the use of aspects of the present disclosure in the context of optical lithography, it will be appreciated that the present disclosure can be used in other applications, for example imprint lithography, and where the context allows, is not limited to optical lithography. In imprint lithography a topography in a patterning device defines the pattern created on a substrate. The topography of the patterning device can be pressed into a layer of resist supplied to the substrate whereupon the resist is cured by applying electromagnetic radiation, heat, pressure or a combination thereof. The patterning device is moved out of the resist leaving a pattern in it after the resist is cured.

It is to be understood that the phraseology or terminology herein is for the purpose of description and not of limitation, such that the terminology or phraseology of the present disclosure is to be interpreted by those skilled in relevant art(s) in light of the teachings herein.

The terms "radiation," "beam of radiation" or the like as used herein can encompass all types of electromagnetic radiation, for example, ultraviolet (UV) radiation (for example, having a wavelength λ of 365, 248, 193, 157 or 126 nm), extreme ultraviolet (EUV or soft X-ray) radiation (for example, having a wavelength in the range of 5-20 nm such as, for example, 13.5 nm), or hard X-ray working at less than 5 nm, as well as matter beams, such as ion beams or electron beams. The terms "light," "illumination," or the like can refer to non-matter radiation (e.g., photons, UV, X-ray, or the like). Generally, radiation having wavelengths between about 400 to about 700 nm is considered visible radiation; radiation having wavelengths between about 780-3000 nm (or larger) is considered IR radiation. UV refers to radiation with wavelengths of approximately 100-400 nm. Within lithography, the term "UV" also applies to the wavelengths that can be produced by a mercury discharge lamp: G-line 436 nm; H-line 405 nm; and/or, I-line 365 nm. Vacuum UV, or VUV (i.e., UV absorbed by gas), refers to radiation having a wavelength of approximately 100-200 nm. Deep UV (DUV) generally refers to radiation having wavelengths ranging from 126 nm to 428 nm, and in some aspects, an excimer laser can generate DUV radiation used within a lithographic apparatus. It should be appreciated that radiation having a wavelength in the range of, for example, 5-20 nm relates to radiation with a certain wavelength band, of which at least part is in the range of 5-20 nm.

It is to be appreciated that the Detailed Description section, and not the Summary and Abstract sections, is intended to be used to interpret the claims. The Summary and Abstract sections can set forth one or more but not all exemplary aspects of the present disclosure as contemplated by the inventor(s), and thus, are not intended to limit the present disclosure and the appended claims in any way.

The present disclosure has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

While specific aspects of the disclosure have been described above, it will be appreciated that aspects of the present disclosure can be practiced otherwise than as described. The descriptions are intended to be illustrative, not limiting. Thus it will be apparent to one skilled in the art that modifications can be made to the disclosure as described without departing from the scope of the claims set out below.

The foregoing description of the specific aspects will so fully reveal the general nature of the present disclosure that others can, by applying knowledge within the skill of the art, readily modify and/or adapt for various applications such specific aspects, without undue experimentation, without departing from the general concept of the present disclosure. Therefore, such adaptations and modifications are intended to be within the meaning and range of equivalents of the disclosed aspects, based on the teaching and guidance presented herein.

The breadth and scope of the protected subject matter should not be limited by any of the above-described exemplary aspects, but should be defined only in accordance with the following claims

## Claims

1. A lithographic apparatus (100) comprising:
an illumination system configured to illuminate a pattern of a patterning device;
a projection system configured to project an image of the pattern onto a substrate; and
a stage (700) configured to move the patterning device or the substrate, the stage comprising:
a support structure (704) configured to support the patterning device or the substrate;
a first actuator target (708) disposed at a first side of the support structure;
a second actuator target (708) disposed at a second side of the support structure opposite the first side;
a third actuator target (708) attached to the first side of the support structure;
an actuator device (710) disposed proximal to the first and third targets and configured to magnetically interact with the first and third targets to move the support structure along a direction; **characterized in** further comprising
a tensional member (718), wherein the first and second actuator targets are attached at opposite ends of the tensional member and the tensional member is configured to transmit a mechanical load to the second side of the support structure via the second actuator target based on a magnetic force exerted on the first actuator target.

2. A lithographic apparatus of claim 1, wherein:
the tensional member is a flexible cord;
the lithographic apparatus further comprises a frame configured to support the support structure and to allow the support structure to move relative to the frame; and
the actuator device comprises a C-shaped core.

3. The lithographic apparatus of claim 1, wherein:
the stage further comprises another actuator target attached to the first side of the support structure;
the actuator device comprises an E-shaped core;
first, second, and third structural projections of the E-shaped core are disposed facing the first, second, and another targets, respectively; and
the E-shaped core comprises two C-shaped cores attached to one another.

4. The lithographic apparatus of claim 1, wherein the actuator device is further configured to move the support structure by pulling on the first side via the third actuator target and by pushing on the second side via the transmitting of the mechanical load to the second side of the support structure via the second actuator target.

5. The lithographic apparatus of claim 1, wherein:
the actuator device is a first actuator device;
the direction is a first direction;
the stage further comprises:
a fourth actuator target (708) attached to the second side of the support structure,
a second actuator device (710) disposed proximal to the second and fourth targets and configured to magnetically interact with second and fourth targets to move the support structure along a second direction opposite the first direction;
the tensional member is further configured to transmit a mechanical load to the first side of the support structure via the first actuator target based on a magnetic force exerted on the second actuator target; and
the second actuator device is further configured to move the support structure by pulling on the second side via the fourth actuator target and by pushing on the first side via the transmitting of the mechanical load to the first side of the support structure via the first actuator target.

6. The lithographic apparatus of claim 1, wherein:
the first and/or second actuator targets comprise a load spreader to spread the mechanical load on the second side;
the third actuator target is attached to the first side via epoxy adhesive; and
a separation gap between the first and third actuator targets is 200 microns or less.

7. The lithographic apparatus of claim 1, wherein a separation gap between the first and third actuator targets is 50 microns or less.

8. A stage (700) comprising:
a support structure (704) configured to support an object (702);
a first actuator target (708) disposed at a first side of the support structure;
a second actuator target (708) disposed at a second side of the support structure opposite the first side, a third actuator target (708) attached to the first side of the support structure;
an actuator device (710) disposed proximal to the first and third targets and configured to magnetically interact with the first and third targets to move the support structure along a direction; **characterized in** further comprising
a tensional member (718), wherein the first and second actuator targets are attached at opposite ends of the tensional member and the tensional member is configured to transmit a mechanical load to the second side of the support structure via the second actuator target based on a magnetic force exerted on the first actuator target.

9. The stage of claim 8, wherein:
the tensional member is a flexible cord;
the stage further comprises a frame configured to support the support structure and to allow the support structure to move relative to the frame; and
the actuator device comprises a C-shaped core

10. The stage of claim 8, wherein:
the stage further comprises another actuator target attached to the first side of the support structure;
the actuator device comprises an E-shaped core; and
first, second, and third structural projections of the E-shaped core are disposed facing the first, second, and another targets, respectively; and
the E-shaped core comprises two C-shaped cores attached to one another.

11. The stage of claim 8, wherein the actuator device is further configured to move the support structure by pulling on the first side via the third actuator target and by pushing on the second side via the transmitting of the mechanical load to the second side of the support structure via the second actuator target.

12. The stage of claim 8, wherein:
the actuator device is a first actuator device;
the direction is a first direction;
the stage further comprises:
a fourth actuator target attached to the second side of the support structure,
a second actuator device disposed proximal to the second and fourth targets and configured to magnetically interact with second and fourth targets to move the support structure along a second direction opposite the first direction;
the tensional member is further configured to transmit a mechanical load to the first side of the support structure via the first actuator target based on a magnetic force exerted on the second actuator target; and
the second actuator device is further configured to move the support structure by pulling on the second side via the fourth actuator target and by pushing on the first side via the transmitting of the mechanical load to the first side of the support structure via the first actuator target.

13. The stage of claim 8, wherein:
the first and/or second actuator targets comprise a load spreader to spread the mechanical load on the second side;
the third actuator target is attached to the first side via epoxy adhesive; and
a separation gap between the first and third actuator targets is 200 microns or less.

14. The stage of claim 8, wherein a separation gap between the first and third actuator targets is 50 microns or less.

## Patentansprüche

1. Ein lithographisches Gerät (100), das Folgendes beinhaltet:
ein Beleuchtungssystem, das konfiguriert ist, um ein Muster einer Musteraufbringungsvorrichtung zu beleuchten;
ein Projektionssystem, das konfiguriert ist, um ein Bild des Musters auf ein Substrat zu projizieren; und
eine Plattform (700), die konfiguriert ist, um die Musteraufbringungsvorrichtung oder das Substrat zu bewegen, wobei die Plattform Folgendes beinhaltet:
eine Stützstruktur (704), die konfiguriert ist, um die Musteraufbringungsvorrichtung oder das Substrat zu stützen;
ein erstes Aktorziel (708), das an einer ersten Seite der Stützstruktur angeordnet ist;
ein zweites Aktorziel (708), das an einer der ersten Seite entgegengesetzten zweiten Seite der Stützstruktur angeordnet ist;
ein drittes Aktorziel (708), das an der ersten Seite der Stützstruktur angebracht ist;
eine Aktorvorrichtung (710), die proximal zu dem ersten und dem dritten Ziel angeordnet ist und konfiguriert ist, um magnetisch mit dem ersten und dem dritten Ziel zu wechselwirken, um die Stützstruktur entlang einer Richtung zu bewegen; **dadurch gekennzeichnet, dass** sie ferner Folgendes beinhaltet:
ein Zugglied (718);
wobei das erste und das zweite Aktorziel an entgegengesetzten Enden des Zugglieds angebracht sind und das Zugglied konfiguriert ist, um auf der Basis einer auf das erste Aktorziel ausgeübten magnetischen Kraft eine mechanische Belastung mittels des zweiten Aktorziels auf die zweite Seite der Stützstruktur zu übertragen.

2. Lithographisches Gerät gemäß Anspruch 1, wobei:
das Zugglied eine biegsame Schnur ist;
das lithographische Gerät ferner einen Rahmen beinhaltet, der konfiguriert ist, um die Stützstruktur zu stützen und zu ermöglichen, dass sich die Stützstruktur relativ zu dem Rahmen bewegt; und
die Aktorvorrichtung einen C-förmigen Kern beinhaltet.

3. Lithographisches Gerät gemäß Anspruch 1, wobei:
die Plattform ferner ein weiteres Aktorziel, das an der ersten Seite der Stützstruktur angebracht ist, beinhaltet;
die Aktorvorrichtung einen E-förmigen Kern beinhaltet;
der erste, zweite und dritte strukturelle Vorsprung des E-förmigen Kerns dem ersten, zweiten bzw. weiteren Ziel zugewandt angeordnet sind; und
der E-förmige Kern zwei C-förmige Kerne beinhaltet, die aneinander angebracht sind.

4. Lithographisches Gerät gemäß Anspruch 1, wobei die Aktorvorrichtung ferner konfiguriert ist, um die Stützstruktur durch Ziehen an der ersten Seite mittels des dritten Aktorziels und durch Drücken auf die zweite Seite mittels des Übertragens der mechanischen Belastung auf die zweite Seite der Stützstruktur mittels des zweiten Aktorziels zu bewegen.

5. Lithographisches Gerät gemäß Anspruch 1, wobei:
die Aktorvorrichtung eine erste Aktorvorrichtung ist;
die Richtung eine erste Richtung ist;
die Plattform ferner Folgendes beinhaltet:
ein viertes Aktorziel (708), das an der zweiten Seite der Stützstruktur angebracht ist;
eine zweite Aktorvorrichtung (710), die proximal zu dem zweiten und dem vierten Ziel angeordnet ist und konfiguriert ist, um magnetisch mit dem zweiten und dem vierten Ziel zu wechselwirken, um die Stützstruktur entlang einer der ersten Richtung entgegengesetzten zweiten Richtung zu bewegen;
das Zugglied ferner konfiguriert ist, um auf der Basis einer auf das zweite Aktorziel ausgeübten magnetischen Kraft eine mechanische Belastung mittels des ersten Aktorziels auf die erste Seite der Stützstruktur zu übertragen; und
die zweite Aktorvorrichtung ferner konfiguriert ist, um die Stützstruktur durch Ziehen an der zweiten Seite mittels des vierten Aktorziels und durch Drücken auf die erste Seite mittels des Übertragens der mechanischen Belastung auf die erste Seite der Stützstruktur mittels des ersten Aktorziels zu bewegen.

6. Lithographisches Gerät gemäß Anspruch 1, wobei:
das erste und/oder das zweite Aktorziel einen Belastungsverteiler beinhalten/beinhaltet, um die mechanische Belastung auf der zweiten Seite zu verteilen;
das dritte Aktorziel mittels Epoxidkleber an der ersten Seite angebracht ist; und
ein Trennspalt zwischen dem ersten und dem dritten Aktorziel 200 Mikrometer oder weniger beträgt.

7. Lithographisches Gerät gemäß Anspruch 1, wobei ein Trennspalt zwischen dem ersten und dem dritten Aktorziel 50 Mikrometer oder weniger beträgt.

8. Eine Plattform (700), die Folgendes beinhaltet:
eine Stützstruktur (704), die konfiguriert ist, um ein Objekt (702) zu stützen;
ein erstes Aktorziel (708), das an einer ersten Seite der Stützstruktur angeordnet ist;
ein zweites Aktorziel (708), das an einer der ersten Seite entgegengesetzten zweiten Seite der Stützstruktur angeordnet ist;
ein drittes Aktorziel (708), das an der ersten Seite der Stützstruktur angebracht ist;
eine Aktorvorrichtung (710), die proximal zu dem ersten und dem dritten Ziel angeordnet ist und konfiguriert ist, um magnetisch mit dem ersten und dem dritten Ziel zu wechselwirken, um die Stützstruktur entlang einer Richtung zu bewegen; **dadurch gekennzeichnet, dass** sie ferner Folgendes beinhaltet:
ein Zugglied (718);
wobei das erste und das zweite Aktorziel an entgegengesetzten Enden des Zugglieds angebracht sind und das Zugglied konfiguriert ist, um auf der Basis einer auf das erste Aktorziel ausgeübten magnetischen Kraft eine mechanische Belastung mittels des zweiten Aktorziels auf die zweite Seite der Stützstruktur zu übertragen.

9. Plattform gemäß Anspruch 8, wobei:
das Zugglied eine biegsame Schnur ist;
die Plattform ferner einen Rahmen beinhaltet, der konfiguriert ist, um die Stützstruktur zu stützen und zu ermöglichen, dass sich die Stützstruktur relativ zu dem Rahmen bewegt; und
die Aktorvorrichtung einen C-förmigen Kern beinhaltet.

10. Plattform gemäß Anspruch 8, wobei:
die Plattform ferner ein weiteres Aktorziel, das an der ersten Seite der Stützstruktur angebracht ist, beinhaltet;
die Aktorvorrichtung einen E-förmigen Kern beinhaltet; und
der erste, zweite und dritte strukturelle Vorsprung des E-förmigen Kerns dem ersten, zweiten bzw. weiteren Ziel zugewandt angeordnet sind; und
der E-förmige Kern zwei C-förmige Kerne beinhaltet, die aneinander angebracht sind.

11. Plattform gemäß Anspruch 8, wobei die Aktorvorrichtung ferner konfiguriert ist, um die Stützstruktur durch Ziehen an der ersten Seite mittels des dritten Aktorziels und durch Drücken auf die zweite Seite mittels des Übertragens der mechanischen Belastung auf die zweite Seite der Stützstruktur mittels des zweiten Aktorziels zu bewegen.

12. Plattform gemäß Anspruch 8, wobei:
die Aktorvorrichtung eine erste Aktorvorrichtung ist;
die Richtung eine erste Richtung ist;
die Plattform ferner Folgendes beinhaltet:
ein viertes Aktorziel, das an der zweiten Seite der Stützstruktur angebracht ist;
eine zweite Aktorvorrichtung, die proximal zu dem zweiten und dem vierten Ziel angeordnet ist und konfiguriert ist, um magnetisch mit dem zweiten und dem vierten Ziel zu wechselwirken, um die Stützstruktur entlang einer der ersten Richtung entgegengesetzten zweiten Richtung zu bewegen;
das Zugglied ferner konfiguriert ist, um auf der Basis einer auf das zweite Aktorziel ausgeübten magnetischen Kraft eine mechanische Belastung mittels des ersten Aktorziels auf die erste Seite der Stützstruktur zu übertragen; und
die zweite Aktorvorrichtung ferner konfiguriert ist, um die Stützstruktur durch Ziehen an der zweiten Seite mittels des vierten Aktorziels und durch Drücken auf die erste Seite mittels des Übertragens der mechanischen Belastung auf die erste Seite der Stützstruktur mittels des ersten Aktorziels zu bewegen.

13. Plattform gemäß Anspruch 8, wobei:
das erste und/oder das zweite Aktorziel einen Belastungsverteiler beinhalten/beinhaltet, um die mechanische Belastung auf der zweiten Seite zu verteilen;
das dritte Aktorziel mittels Epoxidkleber an der ersten Seite angebracht ist; und
ein Trennspalt zwischen dem ersten und dem dritten Aktorziel 200 Mikrometer oder weniger beträgt.

14. Plattform gemäß Anspruch 8, wobei ein Trennspalt zwischen dem ersten und dem dritten Aktorziel 50 Mikrometer oder weniger beträgt.

## Revendications

1. Un appareil lithographique (100) comprenant :
un système d'illumination configuré pour illuminer un motif d'un dispositif servant à conformer selon un motif ;
un système de projection configuré pour projeter une image du motif sur un substrat ; et
une platine (700) configurée pour déplacer le dispositif servant à conformer selon un motif ou le substrat, la platine comprenant :
une structure de support (704) configurée pour supporter le dispositif servant à conformer selon un motif ou le substrat ;
une première cible d'actionneur (708) disposée au niveau d'un premier côté de la structure de support ;
une deuxième cible d'actionneur (708) disposée au niveau d'un deuxième côté de la structure de support opposé au premier côté ;
une troisième cible d'actionneur (708) attachée au premier côté de la structure de support ;
un dispositif actionneur (710) disposé proximal aux première et troisième cibles et configuré pour interagir magnétiquement avec les première et troisième cibles afin de déplacer la structure de support selon une direction ; **caractérisé en ce qu'**il comprend en sus
un élément de tension (718),
où les première et deuxième cibles d'actionneur sont attachées au niveau d'extrémités opposées de l'élément de tension et l'élément de tension est configuré pour transmettre une charge mécanique au deuxième côté de la structure de support via la deuxième cible d'actionneur sur la base d'une force magnétique exercée sur la première cible d'actionneur.

2. Un appareil lithographique de la revendication 1, où :
l'élément de tension est une corde flexible ;
l'appareil lithographique comprend en sus un cadre configuré pour supporter la structure de support et pour permettre à la structure de support de se déplacer relativement au cadre ; et
le dispositif actionneur comprend un noyau en forme de C.

3. L'appareil lithographique de la revendication 1, où :
la platine comprend en sus une autre cible d'actionneur attachée au premier côté de la structure de support ;
le dispositif actionneur comprend un noyau en forme de E ;
des première, deuxième, et troisième projections structurales du noyau en forme de E sont disposées en face des première, deuxième, et autre cibles, respectivement ; et
le noyau en forme de E comprend deux noyaux en forme de C attachés l'un à l'autre.

4. L'appareil lithographique de la revendication 1, où le dispositif actionneur est en sus configuré pour déplacer la structure de support en tirant sur le premier côté via la troisième cible d'actionneur et en poussant sur le deuxième côté via la transmission de la charge mécanique au deuxième côté de la structure de support via la deuxième cible d'actionneur.

5. L'appareil lithographique de la revendication 1, où :
le dispositif actionneur est un premier dispositif actionneur ;
la direction est une première direction ;
la platine comprend en sus :
une quatrième cible d'actionneur (708) attachée au deuxième côté de la structure de support ;
un deuxième dispositif actionneur (710) disposé proximal aux deuxième et quatrième cibles et configuré pour interagir magnétiquement avec les deuxième et quatrième cibles afin de déplacer la structure de support selon une deuxième direction opposée à la première direction ;
l'élément de tension est en sus configuré pour transmettre une charge mécanique au premier côté de la structure de support via la première cible d'actionneur sur la base d'une force magnétique exercée sur la deuxième cible d'actionneur ; et
le deuxième dispositif actionneur est en sus configuré pour déplacer la structure de support en tirant sur le deuxième côté via la quatrième cible d'actionneur et en poussant sur le premier côté via la transmission de la charge mécanique au premier côté de la structure de support via la première cible d'actionneur.

6. L'appareil lithographique de la revendication 1, où :
les première et/ou deuxième cibles d'actionneur comprennent un répartiteur de charge pour répartir la charge mécanique sur le deuxième côté ;
la troisième cible d'actionneur est attachée au premier côté via de l'adhésif époxy ; et
un intervalle de séparation entre les première et troisième cibles d'actionneur est de 200 microns ou moins.

7. L'appareil lithographique de la revendication 1, où un intervalle de séparation entre les première et troisième cibles d'actionneur est de 50 microns ou moins.

8. Une platine (700) comprenant :
une structure de support (704) configurée pour supporter un objet (702) ;
une première cible d'actionneur (708) disposée au niveau d'un premier côté de la structure de support ;
une deuxième cible d'actionneur (708) disposée au niveau d'un deuxième côté de la structure de support opposé au premier côté ;
une troisième cible d'actionneur (708) attachée au premier côté de la structure de support ; un dispositif actionneur (710) disposé proximal aux première et troisième cibles et
configuré pour interagir magnétiquement avec les première et troisième cibles afin de déplacer la structure de support selon une direction ; **caractérisé en ce qu'**il comprend en sus
un élément de tension (718),
où les première et deuxième cibles d'actionneur sont attachées au niveau d'extrémités opposées de l'élément de tension et l'élément de tension est configuré pour transmettre une charge mécanique au deuxième côté de la structure de support via la deuxième cible d'actionneur sur la base d'une force magnétique exercée sur la première cible d'actionneur.

9. La platine de la revendication 8, où :
l'élément de tension est une corde flexible ;
la platine comprend en sus un cadre configuré pour supporter la structure de support et pour permettre à la structure de support de se déplacer relativement au cadre ; et
le dispositif actionneur comprend un noyau en forme de C.

10. La platine de la revendication 8, où :
la platine comprend en sus une autre cible d'actionneur attachée au premier côté de la structure de support ;
le dispositif actionneur comprend un noyau en forme de E ; et
des première, deuxième, et troisième projections structurales du noyau en forme de E sont disposées en face des première, deuxième, et autre cibles, respectivement ; et
le noyau en forme de E comprend deux noyaux en forme de C attachés l'un à l'autre.

11. La platine de la revendication 8, où le dispositif actionneur est en sus configuré pour déplacer la structure de support en tirant sur le premier côté via la troisième cible d'actionneur et en poussant sur le deuxième côté via la transmission de la charge mécanique au deuxième côté de la structure de support via la deuxième cible d'actionneur.

12. La platine de la revendication 8, où :
le dispositif actionneur est un premier dispositif actionneur ;
la direction est une première direction ;
la platine comprend en sus :
une quatrième cible d'actionneur attachée au deuxième côté de la structure de support, un deuxième dispositif actionneur disposé proximal aux deuxième et quatrième cibles et configuré pour interagir magnétiquement avec les deuxième et quatrième cibles afin de déplacer la structure de support selon une deuxième direction opposée à la première direction ;
l'élément de tension est en sus configuré pour transmettre une charge mécanique au premier côté de la structure de support via la première cible d'actionneur sur la base d'une force magnétique exercée sur la deuxième cible d'actionneur ; et
le deuxième dispositif actionneur est en sus configuré pour déplacer la structure de support en tirant sur le deuxième côté via la quatrième cible d'actionneur et en poussant sur le premier côté via la transmission de la charge mécanique au premier côté de la structure de support via la première cible d'actionneur.

13. La platine de la revendication 8, où :
les première et/ou deuxième cibles d'actionneur comprennent un répartiteur de charge pour répartir la charge mécanique sur le deuxième côté ;
la troisième cible d'actionneur est attachée au premier côté via de l'adhésif époxy ; et
un intervalle de séparation entre les première et troisième cibles d'actionneur est de 200 microns ou moins.

14. La platine de la revendication 8, où un intervalle de séparation entre les première et troisième cibles d'actionneur est de 50 microns ou moins.
